(19) **Europäisches Patentamt / European Patent Office / Office européen des brevets**

(11) **EP 1 420 413 B1**

(12) **EUROPEAN PATENT SPECIFICATION**

(45) Date of publication and mention
of the grant of the patent:
**07.01.2009 Bulletin 2009/02**

(51) Int Cl.:
***G11C 11/39*** *(2006.01)*

(21) Application number: **02257827.2**

(22) Date of filing: **12.11.2002**

(54) **Improved memory device**

Verbesserte Speicheranordnung

Dispositif de mémoire perfectionné

(84) Designated Contracting States:
**DE FR GB IT NL**

(43) Date of publication of application:
**19.05.2004 Bulletin 2004/21**

(73) Proprietor: **Hitachi, Ltd.
Chiyoda-ku,
Tokyo 101-8010 (JP)**

(72) Inventors:
• **Nakazato, Kazuo
Cambridge, CB2 2RP (GB)**

• **Furuta, Yoshikazu
Cambridge CB1 2DW (GB)**
• **Mizuta, Hiroshi
Milton,
Cambridge CB4 6DS (GB)**

(74) Representative: **Read, Matthew Charles et al
Venner Shipley LLP
20 Little Britain
London EC1A 7DH (GB)**

(56) References cited:
**US-B1- 6 462 359**

EP 1 420 413 B1

Printed by Jouve, 75001 PARIS (FR)

**Description**

This invention relates to a memory device and to a memory cell array which is operable as a static random access memory of improved, reduced cell size, that has particular but not exclusive application to mobile devices.

A number of different types of memories have been devised hitherto. One well known memory device is the DRAM (Dynamic Random Access Memory) which has a high memory cell density, high read/write speed and unlimited random read/write access to the data. The DRAM cell is a simple structure, consisting of one transistor and one capacitor, and so the cell size is relatively small, $6F^2$ - $8F^2$ where F is the minimum feature size of lithography. For example, in 0.1 microns technology, the area of one memory cell is 0.06 - 0.08 square micro meters, and 1G bits memory array can be formed in 0.6-0.8 $cm^2$ area. In DRAM, one bit of information is stored as electronic charge on a capacitor in each memory cell. Since the stored charge is lost in several seconds by leakage current, the refreshment, reading and re-writing the stored data, is required constantly. This refreshment consumes relatively large standby power, which limits the performance of low power devices, particularly, mobile devices.

Another well known memory type is so-called FLASH memory, which also may have a high cell density, with a cell size of $5F^2$ - $12F^2$. It is non-volatile and so it consumes no significant standby power. However, in FLASH memory, the writing of data is very slow and so FLASH memory is unsuitable for use as a main computer memory.

SRAM (Static Random Access Memory) can operate at high speed and with low standby power. A SRAM cell has two self-maintaining operating states. Internal feedback mechanisms maintain one of the stable states, as long as the power is supplied. Thus, refreshment need not be required, and the standby power can be lower than for a DRAM. However, one SRAM cell typically consists of 4 to 6 transistors and so the cell size is very large, around $120F^2$. Although the standby power may be smaller than that of DRAM, the large cell size limits the application of SRAM, for example making it unsuitable for use within the small confines of mobile devices to meet the demands for larger amounts of data for video and pictures.

It has been proposed to use negative differential resistance (NDR) devices to maintain memory states in a SRAM. As well known, a thyristor exhibits negative differential resistance. Thyristors with a capacitively coupled control gate are described in Japanese patent applications, JP-50-9156 "Semiconductor negative differential resistance devices," by T. Yamashita, Matusita Electric Industrial Co. Ltd., filed on 9 October 1970, and JP-57-208177 "Semiconductor negative differential resistance devices," by Y. Oono, NEC, filed on 17th June 1981.

The configuration of one NDR device and one MOSFET in a memory cell is described in US-A 5 689 458 "Semiconductor memory device having negative resistance element operated stably with single low power source," by H. Kuriyama, Mitubishi, patented on 18 November 1997. In this patent, an NDR device (MIS diode) without a gate is used, but the speed at which data can be written is limited.

SRAM switching between current-pass mode and current-blocking mode by means of a capacitively coupled gate on a thyristor, is described in US-A-6 128 216 "High Density Planar SRAM Cell with Merged Transistors," by W. P. Noble Jr. and L. Forbes, Micron Technology, 3 October 2000.

Vertical NDR memory structures are described in US-A-6 229 161 B1 "Semiconductor capacitively-coupled NDR device and its applications in high-density high-speed memories and in power switches," by F. Nemati and J. D. Plummer, Stanford University, 8 May 2001. However, their configurations are not suitable for constructing practical memory devices. Firstly, data will be destroyed in unselected cells during a write cycle, as explained later. Secondly, the gate of the thyristor is formed on the memory node side. The device's bit line voltage changes according to "0" and "1" data signals, and it can be shown that this requires a relatively large voltage to be applied to the gate of thyristor. Also there is a strong capacitive coupling between the device's memory node and the gate of thyristor. These factors reduce the operational efficiency greatly.

Furthermore, it is desirable to integrate memories and logical processing circuits into a single large scale integrated (LSI) device on a single semiconductor chip. However, the provision of DRAM and CMOS logic circuits on a single chip is rather difficult, because of the large difference in height between them.

According to the invention there is provided a memory device including an array of memory cells each comprising a memory node and a NDR device operable in first mode with a negative differential resistance characteristic which causes first and second different memory states written to the cell to be maintained at the node, and in a second mode without said negative differential resistance, and peripheral circuitry for the array operable to read data from and write data to the cells, the peripheral circuitry being coupled to a plurality of bit and word lines (BL,BW,WL,WW) connected to supply voltage signals to each memory cell, and the peripheral circuitry being operable to write data by changing the NDR device of one of the cells from its first mode to the second mode, setting the memory state of the node whilst the NDR is in said second mode and thereafter changing the NDR to the first mode to maintain the set memory state at the node, wherein the voltage signals control the mode of the NDR device of each memory cell and the bit and word lines are operable to supply the voltage signals to the memory cells to change the NDRs of the memory cells to the second mode for the writing of data, each cell in the array being coupled to a first word line (WL), a second word line (WW), a first bit line (BL) and a second bit line (BW), the NDR of each cell comprising a capacitively-coupled gate (M1) arranged to respond to the second word line (WW), and a current conduction path connected between the second bit line (BW) and the memory node (N) of the cell so as to receive signals from the second word line (WW) and the second bit line (BW) to control the mode of the NDR and to change the mode of the NDR to the second mode, without changing the mode of the NDR in any of the other memory cells so as to maintain the memory states of the nodes thereof during the writing of the data.

Thus, according to the invention, data can be written to and read from individual memory cells without destroying the data stored in other, unselected cells of the array.

The first bit line (BL) may be for exchanging data between inner and outer memory cell arrays, the first word line word line (WL) and second bit (BW) line may be for reading and writing data, and the second word (WW) line may be for selecting read or write operation, wherein the second bit line may comprise a write bit line and the second word line may comprise a write word line.

The cells may be arranged in a two dimensional array (m x n) of rows and columns, with a plurality of the bit lines, word lines, write bit lines and write word lines being arrayed in rows and columns for the cells, and the peripheral circuitry (13,14) being operable to energise the write bit lines (BW) and word lines (WL) individually so as to select an individual one of the cells to have data read from or written thereto.

In one embodiment described in more detail hereinafter the memory cells each consist of one gated thyristor and one MOSFET. In the gated thyristor, a capacitively coupled gate switches the current-voltage characteristics between first and second conduction modes in which the NDR has NDR characteristics and p-n diode characteristics.

The p-n diode characteristics give a relatively large current, resulting in highspeed writing of data.

The NDR characteristics keep the data without refreshment, as long as small power is supplied, so as to provide SRAM cell functionality.

One of the components, namely the gated thyristor or MOSFET, can be formed on the other component. That is to say, when the surface of chip is viewed, the configuration of the first component and the configuration of the second component are partly or entirely overlapped, and accordingly, the cell size can be reduced.

Each memory cell may be connected to two word lines and two bit lines. One bit line and one word line are used for exchanging data between inside and outside memory cell. Another bit line, write bit line, and another word line, write word line, are used for selecting cell to write data. Random write access is possible to just one cell on the cross point of the write bit line and the write word line, without destroying stored data on the other cells. This non-destruction of unselected cells in write cycle realises simple peripheral circuits with one common I/O data line per memory cell array.

The write bit line is also used for keeping voltages unchanged on bit lines of unselected columns in read and write cycle. This reduces noise in memory cell array due to cross-talk between bit lines.

The memory cells can be formed with a similar height to conventional MOSFETs that form the peripheral circuits and logic circuits. Since the top of the memory cells and conventional MOSFETs are nearly equal height, the interconnections become easy. This is suitable to system-on-a chip applications.

The present invention can provide a high density SRAM with a cell size as small as $5F^2$ - $12F^2$, i.e. comparable with DRAM cell. The random access time and standby power are comparable with conventional SRAM, and are superior to those of a DRAM.

In an embodiment of the invention the memory device comprises a first region heavily doped with either p-type or n-type conduction type, a second region doped with the opposite conduction type to the first region, and contacted to the first region, a third region lightly doped with either p-type or n-type conduction type or non-doped, and contacted to the second region, a fourth region doped with the same conduction type as the first region, contacted to the third region, a fifth region heavily doped with the opposite conduction type to the first region, contacted to the forth region, a sixth region lightly doped with either p-type or n-type conduction type or non-doped, contacted to the fifth region, a seventh region heavily doped with the opposite conduction type to the first region, contacted to the sixth region, the first gate contacting at least a part of the surface of the second region through insulator, and the second gate contacting a part of or full of the surface of the sixth region through insulator

In order that the invention may be more fully understood embodiments thereof will now be described by way of example with reference to the accompanying drawings in which:

Fig. 1 illustrates the schematic circuitry of a 2x2 memory cell array according to the present invention,

Fig. 2 is a schematic diagram of the configuration of the NDR shown in the memory cell array of Figure 1,

Figure 3 is a schematic equivalent circuit of the NDR of Figure 2,

Figure 4 is a graph of the NDR's current-voltage characteristics at gate voltage VG=0V and -1.5V,

Figure 5 is a graph of the NDR's turn voltage $V_{turn}$ as a function of gate voltage VG,

Fig. 6 is a more detailed circuit diagram of one of the memory cells shown in Figure 1,

Figure 7 is a plot of the voltages and currents at the memory node N shown in Figure 6 to illustrate the principle of operation of the memory cell,

Figure 8 comprises graphs corresponding to Figure 7 under conditions for writing data to the cell, wherein Figs 8A and 8B illustrate the voltages applied to write a "1" and "0" respectively, and Figs 8C and 8D illustrate the voltages that respectively occur after a "1" and "0" have been written,

Figure 9 comprises graphs corresponding to Figure 7 under conditions for reading data from the cell, wherein Figs 9A and 9B illustrate the voltages applied to read "1" and "0" respectively,

Figure 10 is a plot of the voltages and currents at the memory node N during a standby mode,

Fig. 11 is a schematic circuit diagram of a memory cell array according to the invention with associated row and column drivers and decoders,

Fig. 12 is waveform diagram illustrating a process for writing data to the memory cell $M_{ij}$ .

Fig. 13 is waveform diagram illustrating a process for reading data from the memory cell $M_{ij}$,

Fig. 14 is a schematic plan view of a memory cell array in accordance with the invention.

Fig. 15 is a schematic cross sectional view corresponding to the line A-B in Fig. 14,

Fig. 16 is a schematic plan view of another memory cell array in which each cell comprises a stacked arrangement of an NDR and a MOS transistor together with CMOS drive transistors, in accordance with the invention.

Fig. 17 is a schematic cross sectional view corresponding to the line A-B-C in Fig. 16,

Fig. 18 illustrates a series of fabrication steps with schematic cross sectional view corresponding to the line A-B-C in Fig. 16, for producing a memory device in accordance with the invention,

Fig. 19 is a graph of the impurity profiles in the memory cell of Fig. 16-18.

Fig. 20 is a schematic plan view of another memory cell array in which an NDR and a MOS transistor are planar formed in a SOI substrate.

Fig. 21 is a schematic cross sectional view of the array of Fig. 20.

Fig. 22 illustrates a series of fabrication steps in schematic cross sectional view of Fig. 20, for producing a memory device in accordance with the invention.

Fig. 23 shows the impurity profiles in the memory cell of Fig. 20-22.

Fig. 24 illustrates the schematic cross sectional view of memory cell using MIS (metal-insulator-semiconductor) NDR device with capacitively coupled gate, instead of a gated thyristor, and

Figure 25 illustrates the circuit of a prior art SRAM that uses a NDR.

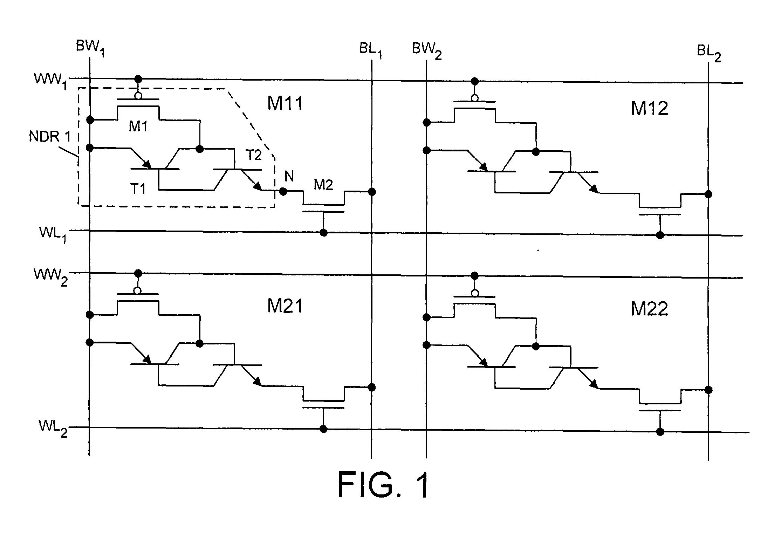

Fig. 1 is a schematic illustration of the circuitry of a 2x2 memory cell array according to the present invention. The array is made up of two rows and columns of memory cells $M_{11}$, $M_{12}$ and $M_{21}$, $M_{22}$ although it will be appreciated that in practice the array will include a much larger number of them. Each cell M is coupled to two bit lines BW, BL and two word lines WW, WL as shown, to allow binary data to be written to the cells individually and for the binary data in a cell to be read individually. Each cell M includes a negative differential resistance device NDR and a memory node N.
Considering the cell $M_{11}$ in more detail by way of example, it includes a NDR device NDR1 which, as will be discussed in detail hereinafter, has an equivalent circuit that comprises NPN and PNP transistors T1 and T2 interconnected as shown, which corresponds to the circuit of a thyristor gated by a first MOSFET transistor M1. The device NDR1 is coupled to the memory node N which is coupled to a second MOSFET M2.

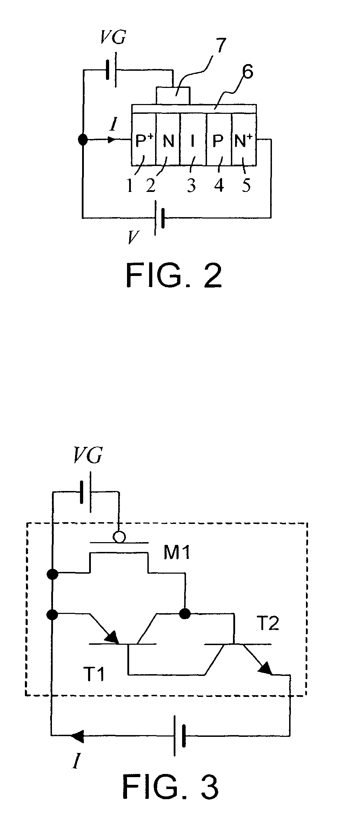

A schematic illustration of the structure of NDR1 is shown in Figure 2 which comprises overlying layers of semiconductor material 1-5 with the following characteristics:

Layer 1 - P-type $10^{20}$ cm$^{-3}$ having a thickness of 100nm
Layer 2 - N-type $10^{18}$ cm$^{-3}$ having a thickness of 100nm
Layer 3 - N-type $10^{16}$ cm$^{-3}$ having a thickness of 200nm
Layer 4 - P-type $10^{18}$ cm$^{-3}$ having a thickness of 100nm
Layer 5 - N-type $10^{20}$ cm$^{-3}$ having a thickness of 100nm

A gate insulator 6 of e.g. thermally grown silicon dioxide of a thickness 10nm is formed alongside the layers 1-5 and overlaid by gate 7, for example of polysilicon heavily doped to $4 \times 10^{20}$cm$^{-3}$ with phosphorus.

The role of the low dopant concentration layer 3 (N-type $10^{16}$ cm$^{-3}$, in this case) is to firstly to weaken the electric field so as to reduce the OFF current of the NDR, and secondly to provide a margin of error in respect to the position of the gate. The gate 7 should overlie the left N-layer 2 but not the layer 4. The overlap of the gate 7 over the low concentration layer 3 does not change the electrical characteristics of the device, but if the gate 7 overlaps the right P-layer 4 there is a substantial change in the electrical characteristics and so the layer 3 provides a certain amount of tolerance in the alignment of the gate 7.

The equivalent circuit of the NDR is shown in Figure 3 and the components correspond to those shown in Figure 1. In order to explain the electrical characteristics of the NDR, the current I produced in response to a voltage V applied across the layers 1 - 5 and a voltage VG applied to the gate 7, will be considered.

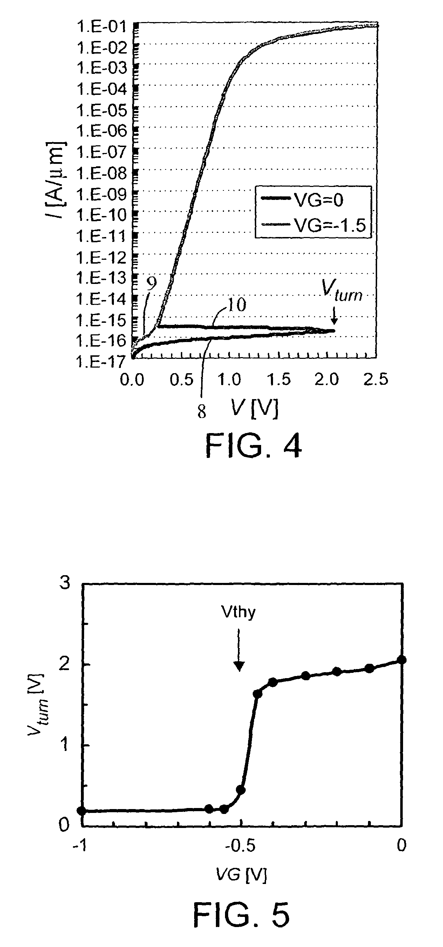

Figure 4 is a graph of the voltage developed across the layers 1 - 5 of the device plotted as a function of the current *I*. The voltage/current characteristic varies as a function of the gate voltage *VG*. Figure 4 illustrates two plots for different values of gate voltage. Plot 8 corresponds to *VG* = 0 and plot 9 corresponds to *VG* = -1.5v.

Considering plot 8, in the absence of a gate voltage i.e. *VG* = 0, the device exhibits a negative differential resistance in re-entrant curve region 10, for which an increase in voltage produces a corresponding decrease in current. The NDR region 10 extends from a voltage discontinuity $V_{turn}$.

The negative differential resistance characteristic can be changed into a more conventional p-n diode characteristic 9 by applying a negative voltage to the gate region 7, as illustrated in Figure 5, in which the voltage $V_{turn}$ is plotted against gate voltage *VG*. When the gate voltage reaches the value of approximately -0.5V, the value of $V_{turn}$ increases stepwise to the value shown in plot 8 in Figure 4. Thus, the NDR characteristic can be selectively switched on and off by applying an appropriate voltage to the gate region 7.

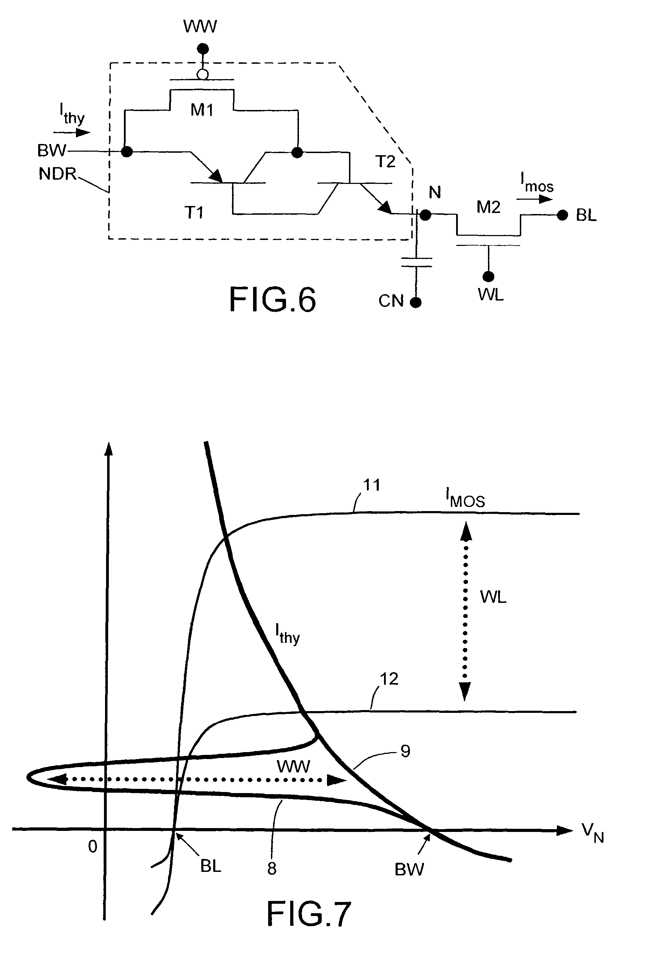

The operation of one of the memory cells M will now be described with reference to Figures 6 and 7. Figure 6 illustrates an example of the NDR coupled to memory node N via transistor M2 e.g. as shown in memory cell $M_{11}$ of Figure 1. The memory node N has an associated capacitance $C_N$ due to a gate capacitance and p-n junction capacitances that inherently occur in the configuration of the device. The bit and word lines BW, WW, WL and BL are connected as shown to the NDR and MOS transistor M2.

The voltages applied to the various bit and word lines can be switched between relatively high levels signified by suffix H and low levels signified by suffix L hereinafter. Furthermore, the voltages will for convenience in the following discussion be referred to in terms of their bit and word line designations, for example the voltage pertaining on line WW will be referred to as WW and this may have a value WWL or WWH.

Figure 7 illustrates the currents that occur at the memory node N in Figure 6. The voltage on word line WW switches the characteristics of the NDR between p-n diode characteristics when WW-BW < Vt and negative differential resistance characteristics when WW-BW > Vt, as illustrated by curves 9 and 8 in Figure 7.

The voltage on WL switches the MOS transistor M2 between an ON state when WL=WLH, and an OFF state when WL=WLL, as illustrated by curves 11 and 12 in Figure 7. As previously discussed, WLH > WLL.

The voltage on BW and BL shifts the current-voltage characteristics of the NDR and MOS transistor M2, respectively.

Considering the voltage $V_N$ of the memory node N, at relatively high current, the voltage of the memory node N is set by the current continuity condition Ithy = $I_{MOS}$ where Ithy is the current through the NDR and $I_{MOS}$ is the current through the transistor M2. This corresponds to the intersection of the relevant curves for the NDR and the transistor M2 shown in Figure 7.

At relatively low current i.e. when the transistor M2 is in an OFF state, it takes a relatively long time to charge the memory node voltage $V_N$ due to its capacitance $C_N$ and thus the node can store charge to provide a memory effect.

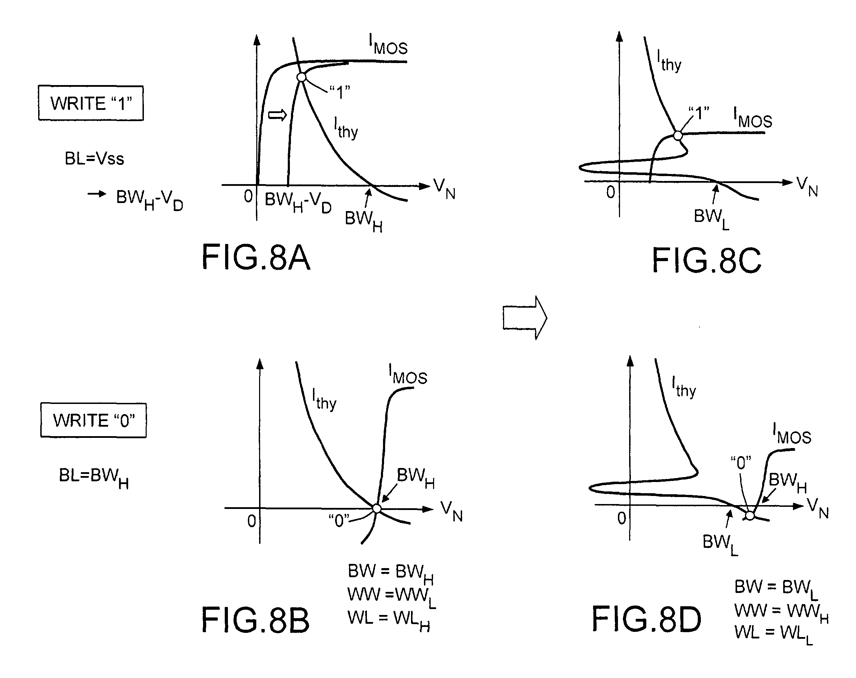

*(i) write cycle (Fig. 8)*

Data is written to an individual one of the memory cells M by configuring the various bit and word line voltages so that the NDR of the selected cell is switched to its p-n characteristic i.e. curve 9 of Figure 4 whereas the other, unselected cells have their NDRs with a negative resistance characteristic i.e. curve 8 of Figure 4.

More specifically, BW=BWH on the column for the selected memory cell, WW = WWL and WL = WLH on the selected cell row. The other bit lines BW are kept at BWL, and the other word lines are kept at WW=WWH and WL=WLL. As previously explained, BWH > BWL, WWH > WWL, and WLH > WLL.

As shown in Figure 8A, in order to write "1" to the selected cell, the bit line BL is biased from an initial value of $V_{SS}$ (0V) to a value of less than BWH-VD, where VD is ON voltage of p-n diode characteristic 9 of the NDR. A value for VD is 0.9V which corresponds to 10uA/um of ON current as shown in Fig. 4. Current flows mainly through the NDR, the voltage of BL is shifted to BWH-VD, and the voltage $V_N$ of the memory node N is held at a value of BWH-VD, which corresponds to high current state.

As shown in Figure 8B, in order to write "0", bit line BL is biased to BWH. The voltage $V_N$ of the memory node N then corresponds to around BWH, which corresponds to low current state.

The NDR of the selected cell is configured have p-n diode characteristics. This condition is given by

$$\text{WWL - BWH} < \text{Vt} \qquad (1)$$

However, the NDRs of the unselected cells have negative resistance characteristics and as a result hold data already stored therein during the writing of data to the selected cell. The conditions for producing the negative differential characteristic are:

$$\text{WWL - BWL} > \text{Vt} \qquad (2)$$

$$\text{WWH - BWH} > \text{Vt} \qquad (3)$$

$$\text{WWH - BWL} > \text{Vt} \qquad (4)$$

These conditions are satisfied by

$$\text{WWH - Vt} > \text{BWH} > \text{WWL - Vt} > \text{BWL} \qquad (5)$$

In the present case,

$$\text{Vt} = {}^{-}0.3\text{V}$$

$$\text{WWH} = \text{BWH} = 1.5\text{V}$$

$$\text{WWL} = \text{BWL} = 0.75\text{V}$$

After either a "1" or "0" is written to the selected cell, the various bit and word line voltages are changed so that the NDR device of the cell adopts its negative resistance characteristic 8 rather than the p-n characteristic 9 that was used during the writing process.

Figure 8C indicates the conditions after writing "1" to the selected cell whereas Figure 8D indicates the conditions after "0" is written to the cell. It can be seen from a comparison of Figures 8C and 8D that the negative resistance part 10 of the characteristic 8 separates the "1" and "0" voltages, thereby making it difficult for externally applied voltages to disturb the voltage of the node N from a "1" state to a "0" state and *vice versa*.

In order to re-establish the NDR characteristic after the writing of data to the selected cell, BW is set to BWL, WW is set to WWH, and WL is set to WLL in all cells. The NDR of the selected cell is thereby switched to a condition exhibiting negative differential resistance and the "1" or "0" state written to the selected cell is held stored on its memory node N. Furthermore, data on unselected cells are not destroyed through these operations as will be explained in more detail hereinafter.

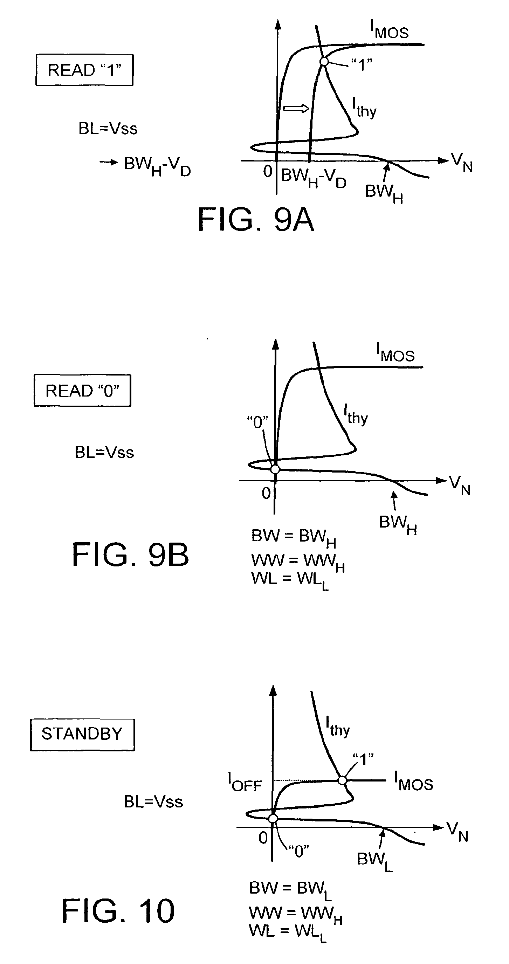

*(ii) read cycle (Fig. 9)*

Data is read from a selected cell by setting the NDR devices for all cells so that they exhibit negative differential resistance, and the voltage on the memory node N for the selected cell is sensed on the bit line BL for the selected cell, by switching on transistor M2 for the cell concerned. Thus, BW = BWH on the selected column, WW = WWH in all cells in order to selected the negative resistance characteristic, and WL = WLH on the selected row in order to switch on the transistor M2 for the selected cell. The other write bit lines are kept at BW = BWL. The other word lines are kept at WL = WLL.

The bit line BL is pre-charged to Vss (0V). When the memory state is "1", current flows through the NDR and MOS transistor M2, and voltage on BL voltage becomes BWH-VD, a relatively high value as shown in Figure 9A. When the memory state is "0", current does not flow, and voltage on BL stays at Vss, a relatively low value, as shown in Figure 9B. Therefore, data can read from the memory cell by detecting the voltage level on BL for the cell concerned.

For unselected columns, BW is set to BWL. The resulting current through the cell is small even if data "1" is stored, and so BL stays at the pre-charge voltage Vss. This situation reduces power consumption and noise greatly.

The relationship between the voltage on bit line BW and VD is given by:

$$BWH > VD > BWL \qquad (6)$$

Thus, in the read cycle, no data in any of the cells are destroyed.

*(iii) standby cycle (Fig. 10)*

In the standby cycle, i.e. when no data is written to or read from selected cells, BW = BWL, WW = WWH, and WL = WLL.

The bit line BL may be pre-charged to Vss (0V). The OFF current of the MOS transistor M2, $I_{OFF}$, maintains the memory states on the memory node N. $I_{OFF}$ may be 10 fA in this example. The value of $I_{OFF}$ can be determined by adjusting the threshold voltage or the controlling GIDL (gate induced drain leakage) current of the MOSFET M2. The threshold voltage can be selected by an appropriate choice of its gate material (doping and/or SiGe) and/or by channel doping. The GIDL current can be selected by selecting the thickness of gate insulator 6. In the case of threshold voltage control, since the OFF current has strong dependence of threshold voltage, one order per 60mV, and threshold voltage can be varied around 0.2V among the transistors in the memory device, and word line voltage can change due to noise, a large current margin of 3 orders of magnitude, may be necessary. Therefore, the OFF current is designed to be a relatively large current, so standby power increases. In the case of GIDL, the OFF current has a weak dependence on the word line voltage WL, and so the OFF current can be designed to be relatively low if the GIDL current can be controlled precisely.

A disturbed state for a memory cell will now be considered, when the cell itself is not selected for reading or writing data, but another cell is selected for reading or writing. The stored data for the disturbed cell should not be destroyed by the bit line and word line voltages applied for reading or writing data to another cell.

During a disturbed state, a number of different voltage conditions can occur for the cell concerned, which will now be reviewed. When WL=WLH, i.e. when transistor M2 is in its ON state, BL is kept at Vss in unselected cells, and the negative differential resistance characteristic 8, 10 holds the "0" and "1" states at the memory node N for the cell concerned. When WL=WLL, BL can be between Vss and BWH, but the current is low because the MOS transistor M2 is in its OFF state. In this situation, the memory node capacitance CN holds the "0" and "1" states at the memory node N. The memory node capacitance CN has a value of around 0.1 fF in a typical configuration. Since the currents through the NDR and the transistor M2 are less than 10 fA, it takes 10 m sec to change the memory node voltage. However, the disturbed state occurs for less than 1 microsecond, and so the memory state is not destroyed.

*Memory cell array*

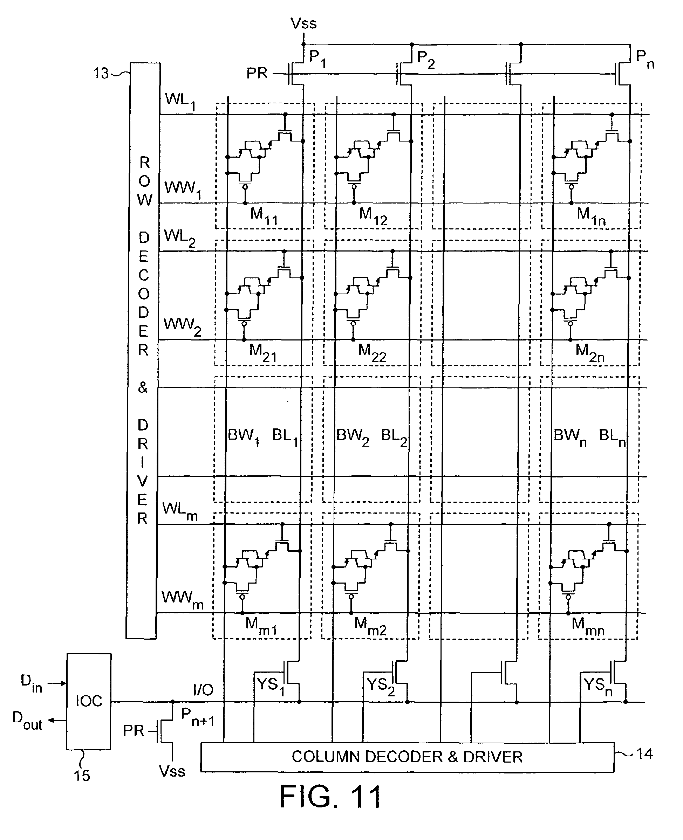

Fig. 11 illustrates an example of a memory device according to the invention that comprises a m x n memory cell array $M_{11}$ — $M_{mn}$. Each of the cells has a circuit configuration as shown and described with reference to Figure 1 and will not be described again in detail. The bit BW, BL and word WW, WL lines for the m rows and n columns of the memory cells M are decoded and driven by row and column peripheral circuits 13, 14. The bit lines $BL_1$ — $BL_n$ are coupled to the pre-charge voltage source $V_{ss}$ through pre-charge control transistors $P_1$-$P_n$, the gates of which receive a common pre-charge signal PR. Outputs on the bit lines $BL_1$ - $BL_n$ are coupled onto a common input/output line I/O by sensing pass gate transistors $YS_1$ -$YS_n$ the gates of which are controlled by the column decoder and driver circuit 14. The input/output line I/O can also be pre-charged to $V_{ss}$ by means of pre-charge transistor $P_{n+1}$ under the control of the pre-charge signal PR. An input/output circuit 15 is coupled to the input/output line I/O which receives input data $D_{in}$ and provides output data $D_{out}$.

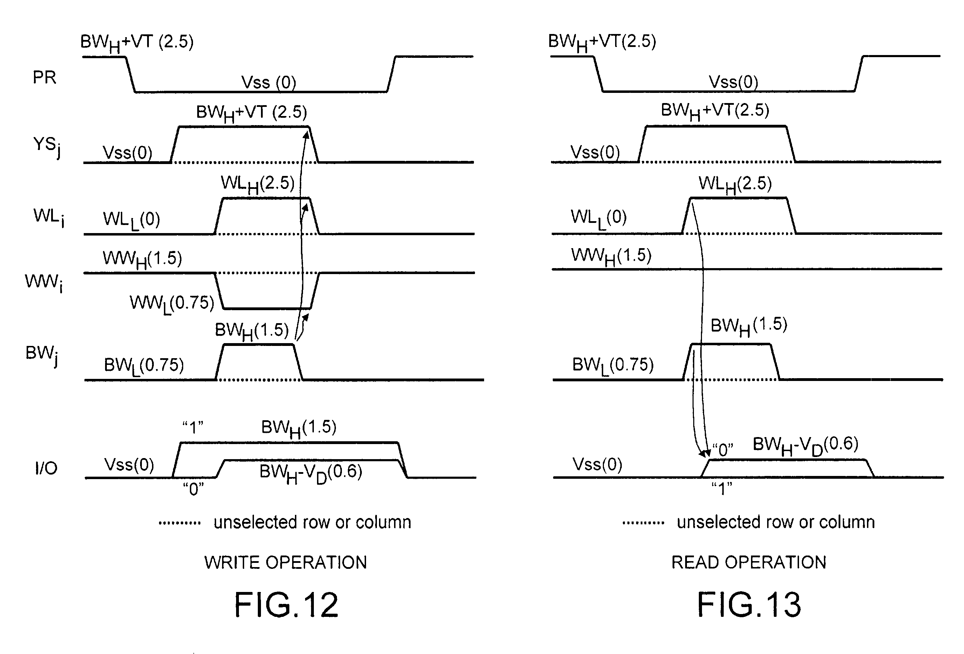

Figures 12 and 13 illustrate operational waveforms for the writing and reading of data in memory cell $M_{ij}$ of the array of Figure 10. VT is the voltage difference between the gate and source of MOS transistor M2 in the ON state. In this example, VT=1V, VD=0.9V, Vss=0V, WWH=BWH=1.5V, WWL=BWL=0.75V, WLL=0V, WLH=2.5V. The voltage on BL of selected column is same as the voltage on I/O line. The voltage on the bit lines BL of unselected columns are kept at Vss during read and write cycles. Thus, there is essentially no cross talk between the bit lines BLs.

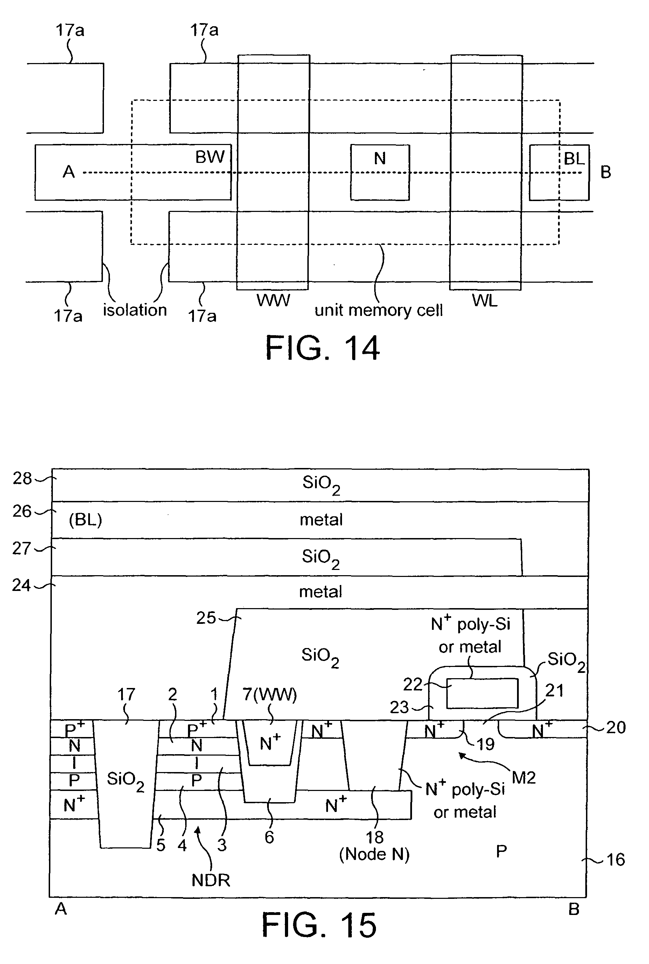

An example of the structure of a memory cell of a device according to the invention, is shown in plan view in Figure 14, with a corresponding sectional view being presented in Figure 15, taken along the line A-B. The cell is formed in a P-type substrate 16 and the NDR device comprises overlying P+, N, I, P and N+ layers 1-5 configured in an overlying relationship, the layers 1-5 having the thicknesses and dopant concentrations previously described with reference to Figure 2.

The gate insulator 6 comprises a well of polysilicon material which abuts side edges of the layers 1-4 and extends into the layer 5. A well of N$^+$ silicon is configured within the well 6 to form the gate electrode 7 of the NDR, which extends as an elongate strip to form the word line WW.

An elongate isolation region 17 formed of insulating material such as silicon dioxide, separates the active layers 1-5 of the NDR from the next adjacent memory cell in the array.

A conductive region 18 forms the node N of the cell. The region 18 may be formed of metal or N$^+$ polysilicon.

The MOS transistor M2 comprises N$^+$ source and drain regions 19, 20 on opposite sides of a channel region 21 in the P-type substrate 16. The channel region 21 is overlaid by a conductive region 22 that forms the gate of the transistor, insulated from the channel by an oxide region 23. The gate region 22 may be formed of N$^+$ polysilicon or metal and is configured as an elongate strip so as to provide the word line WL.

The bit line BW comprises metallic layer 24 which makes contact with the layer 1 of the NDR. An insulating layer 25 of e.g. silicon dioxide overlies the gate 22 of the transistor M2. The bit line BL comprises a metallic layer 26 separated from the layer 24 by an insulating oxide layer 27. The bit line BL contacts the drain 20 of transistor M2. The memory cell array is covered by a protective insulating layer 28 of silicon dioxide.

It will be understood that a large number of the memory cells can be formed in an array in the substrate 16, with the layers 1-5 being suitably partitioned into individual memory cells by isolation regions such as 17 shown in Figure 15 and regions 17a shown in Figure 14.

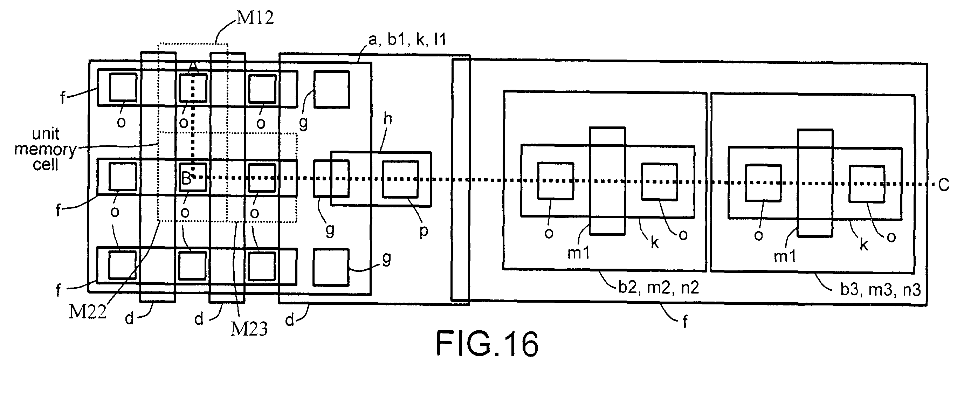

Another example of memory cell array according to the invention will now be described with reference to Figures 16, 17 and 18. In this example of the memory cell array, the NDR and MOS transistor M2 are arranged in a vertical, stacked configuration so as to reduce the size of the memory cells.

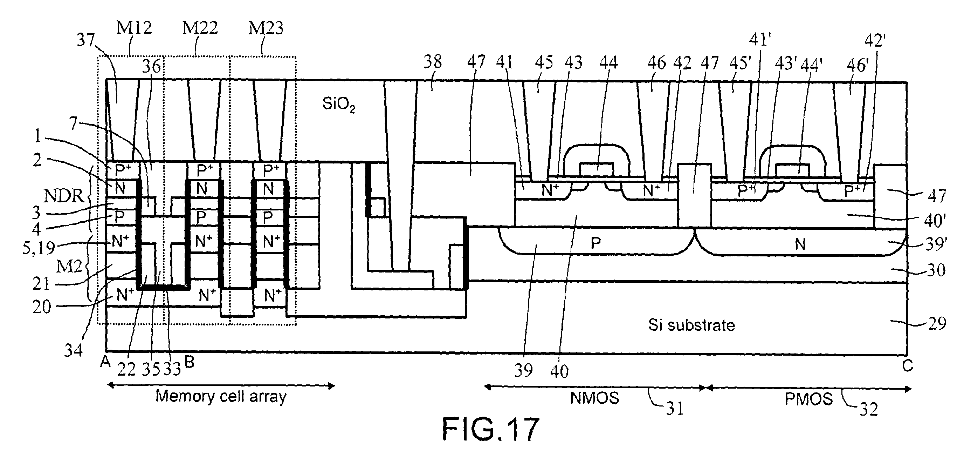

Figure 16 illustrates the memory cell array in plan view and outlines masks that are used during the fabrication process. Figure 17 is a sectional view taken along line A-B-C shown in dotted outline in Figure 16. Three of the individual memory cells are shown together with an example of an NMOS and PMOS transistor that can be used for the drive circuits 13, 14 shown in Figure 11.

As can be seen from Figure 16, an illustrative 3x3 memory cell array is shown and memory cells $M_{12}$, $M_{22}$ and $M_{23}$ fall on the section line A-B-C. These three cells are thus shown in section in Figure 17.

In general outline, the device shown in Figure 17 comprises a silicon substrate 29 that contains an N-type well 30 which includes an NMOS transistor 31 and a PMOS transistor 32 that can be used in the drive circuits 13, 14. The substrate 29 also includes the array of memory cells M and the cell $M_{12}$ will now be described in more detail. The cell $M_{12}$ includes an NDR in which the layers 1-5 are arranged overlying one another in a stacked configuration. The NDR overlies transistor M2 which comprises overlying source and drain regions 19, 20, separated by a P-type doped epitaxial silicon region 21 that forms its channel. The transistor M2 has a gate 22 formed on N$^+$ material formed in a well 33, as a side gate. The NDR has its gate 7 configured as a side gate above the gate 22, within the well 33. The gate 7 for the NDR is formed of P$^+$ semiconductor material. Both of the gates 7, 22 are electrically insulated by a silicon dioxide layer 34 that lines the well 33, and also by silicon dioxide regions 35, 36.

An electrically conductive via 37 extends vertically upwardly through a silicon dioxide covering layer 38 to enable bit lines BW to be provided between the cells of an individual column (not shown).

The memory cells $M_{22}$ and $M_{23}$ are constructed in a similar manner, making use of the layers 1-5 and the layers 19, 20, 21 that make up the transistor M2.

Considering the NMOS transistor 31, it is formed in a P-type well 39 and includes P-type region 40 into which N-type source and drain regions 41, 42 are formed, overlaid by an insulating layer 43 and a gate region 44. Metal vias 45 and 46 provide external source and drain connections through the layer 38. A silicon dioxide isolation region 47 is disposed between the complimentary transistors 31, 32.

The PMOS transistor 32 is of a complimentary construction and like parts to those of transistor 31 are shown with the same reference numbers marked with a prime.

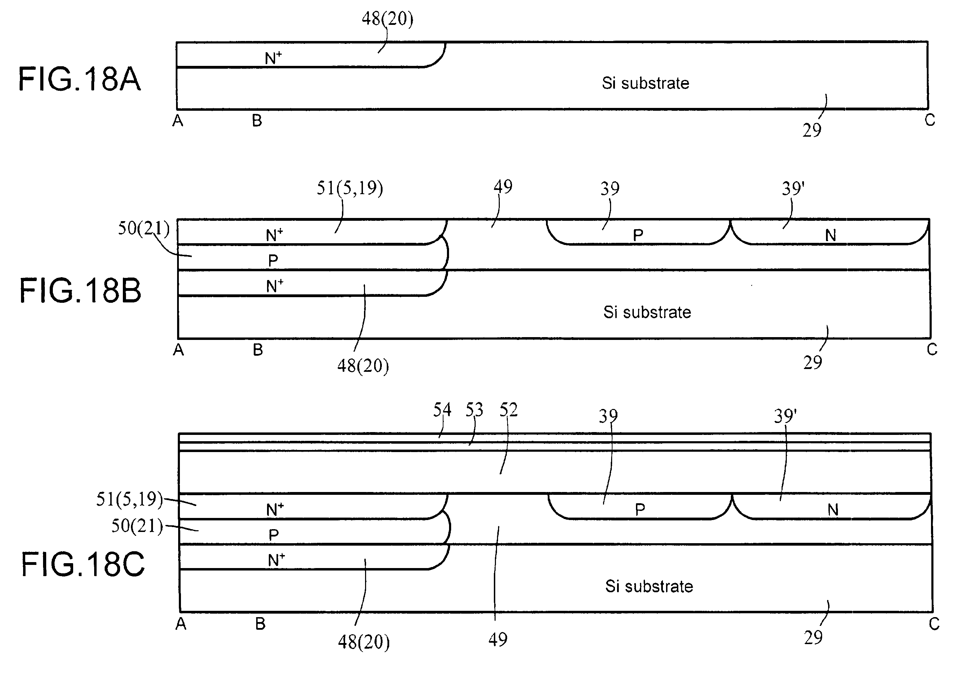

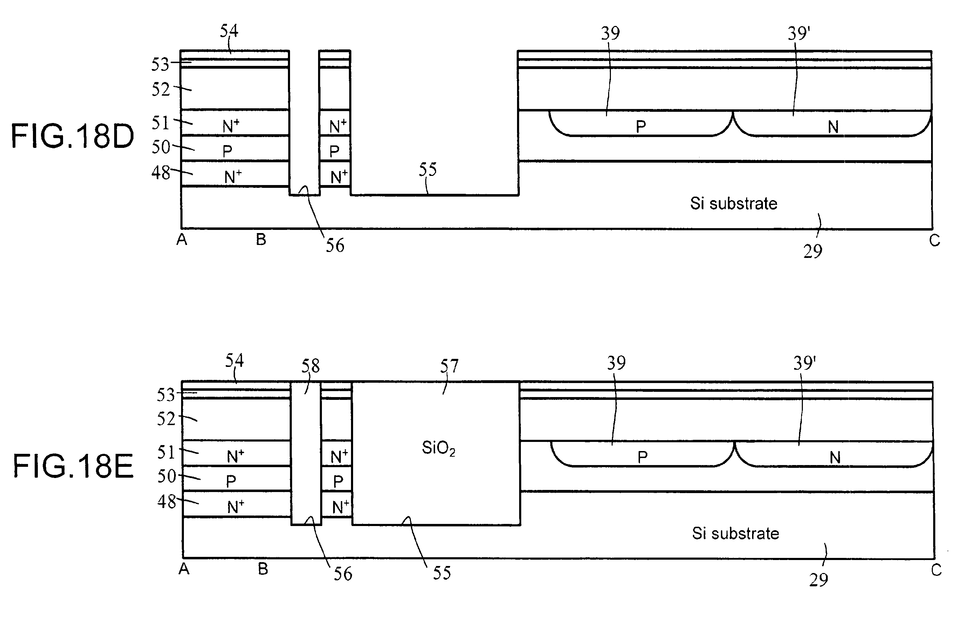

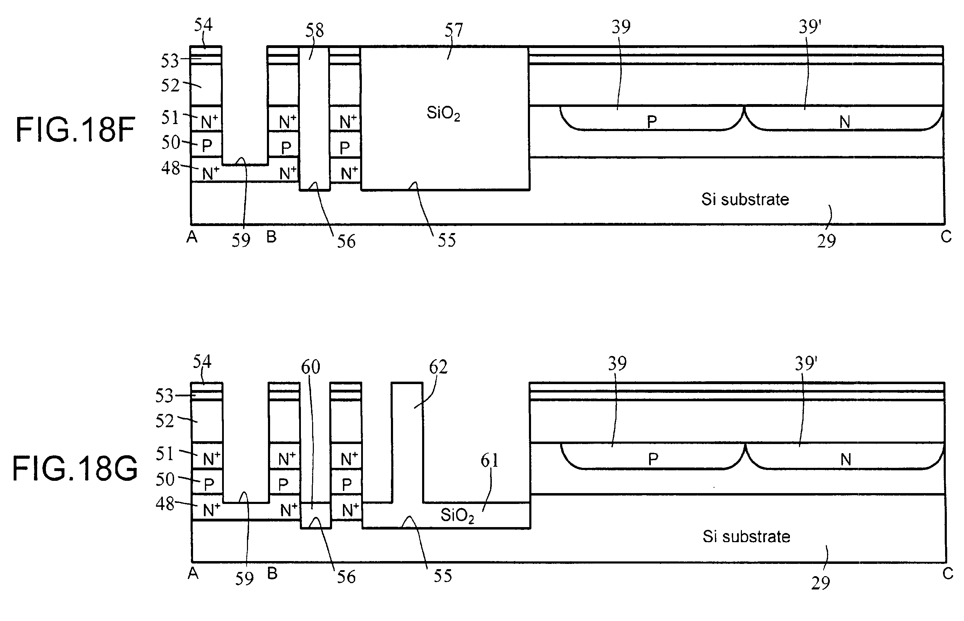

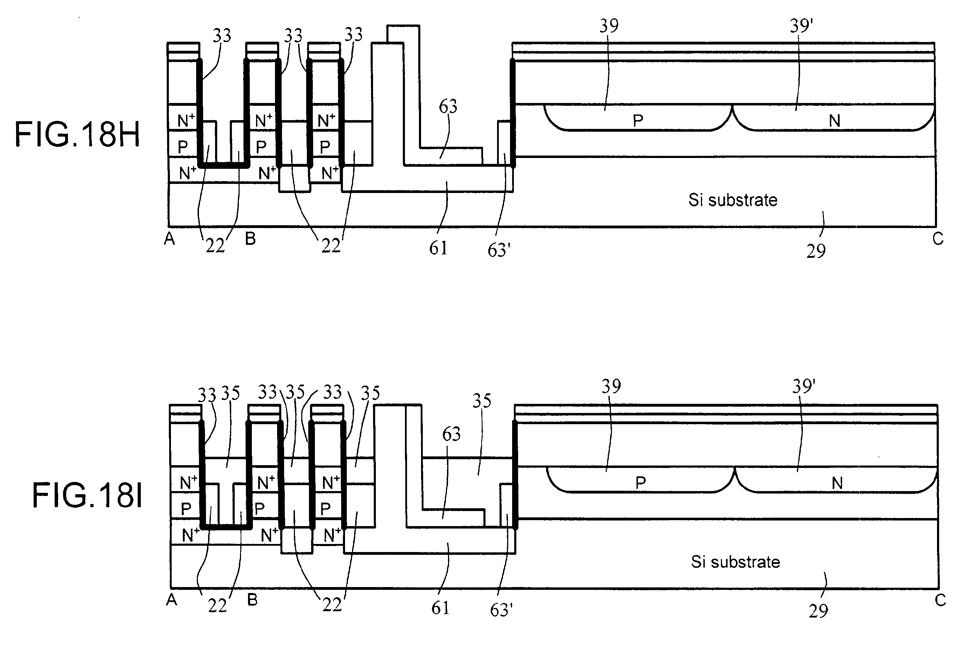

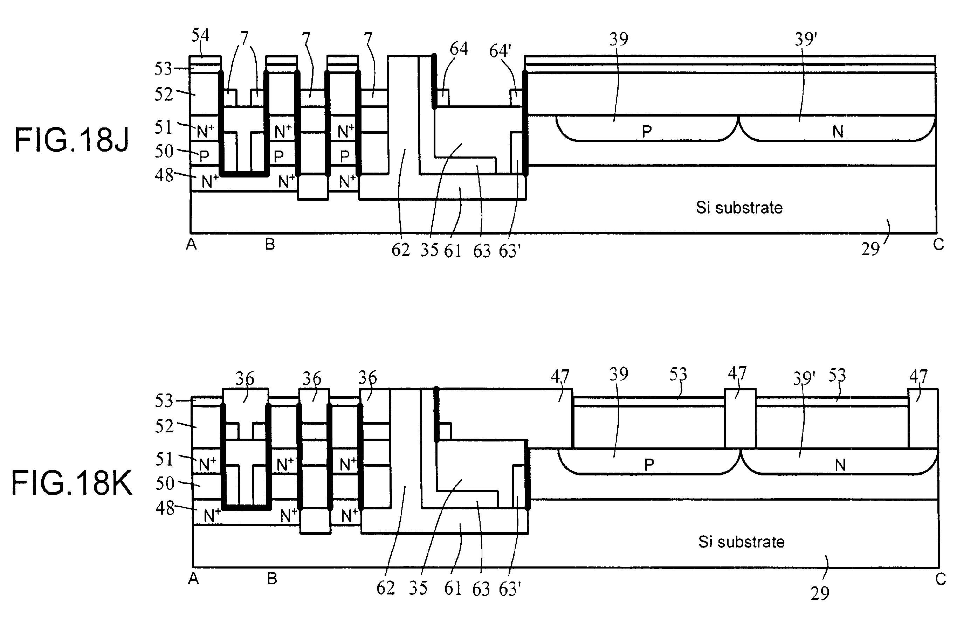

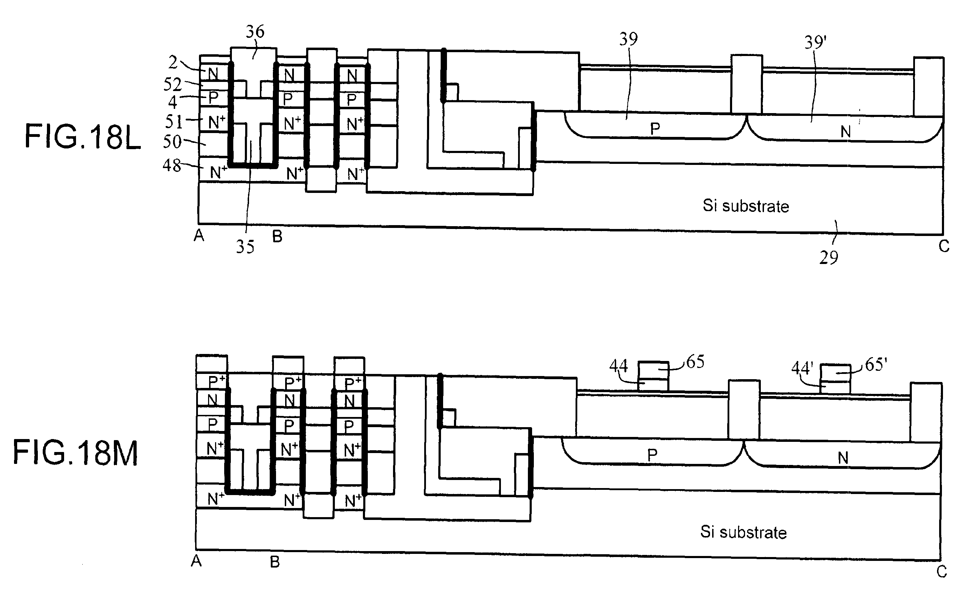

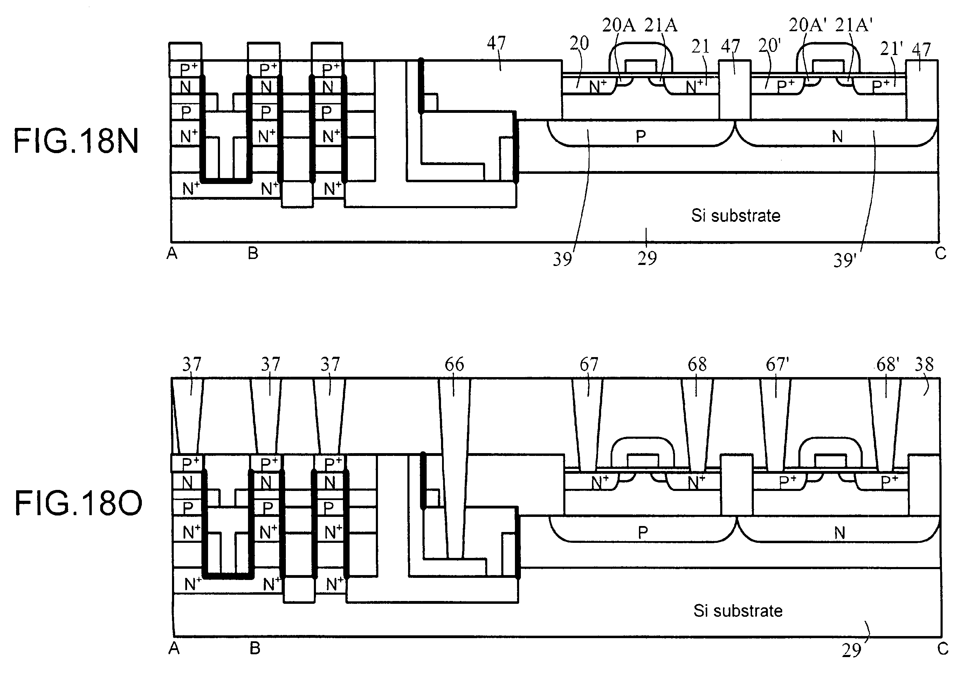

Fabrication of the device of Figure 17 will now be described with reference to Figure 18.

As shown in Figure 18A, the substrate 29 is subjected to photolithography according to conventional techniques, using mask *a* shown in Figure 16. The unmasked region is subject to arsenic implantation 200 keV, $2x10^{15}cm^{-2}$ to a dopant concentration of $2x10^{20}cm^{-3}$ in order to form an $N^+$ region 48 that will form the drain 20 of the transistor M2 in the eventual device. Thereafter, the photoresist that formed the mask is removed, resulting in the configuration shown in Figure 18A.

Referring to Figure 18B, a layer 49 of non-doped epitaxial silicon is deposited to a thickness of 300 nm. It's upper surface is then treated with photoresist to form mask *b1* of Figure 16, by conventional photolithographic techniques.

The unmasked area is then subject initially to boron implantation 60 keV, $2.5x10^{13}cm^{-2}$ to form $P^+$ region 50 that will form the channel of transistor M2. Thereafter, the unmasked region is subject to arsenic implantation 60 keV, $2x10^{15}cm^{-2}$ to form $N^+$ region 51 that eventually forms the source of transistor M2 and also the layer 5 in the NDR. The mask *b1* is then removed according to conventional techniques.

The P well 39 for the NMOS transistor 31 is then formed. The mask b2 shown in Figure 16 is formed by conventional photolithographic techniques and boron implantation is carried out into the well region 39. The mask is then removed. A corresponding N-well 39' is produced using mask *b3* in a similar manner, using phosphorous implantation. The mask *b3* is thereafter removed together with the remaining oxide layer.

Referring to Figure 18C, a layer 52 of undoped, expitaxial silicon is deposited to a thickness of 300 nm. The layer 52 is then covered with a layer 53 of silicon dioxide to a thickness of 10nm which itself is overlaid by a layer 54 of silicon nitride to a thickness of 180 nm.

Referring to Figure 18D, the mask d shown in Figure 16 is used to etch wells 55 and 56 into the device using a dry etching process. The photoresist used to form mask d is then removed.

Referring to Figure 18E, silicon dioxide is deposited in wells 55 and 56 to a thickness of the order of 1200 nm. The upper surface is then subjected to chemical mechanical polishing (CMP) until the surface of the silicon nitride layer 54 is detected. Thus the wells 55, 56 become filed with regions 57, 58 of silicon dioxide. Referring to Figure 18F, the mask *f* shown in Figure 16 is applied to the surface of the device and a dry etching process is carried out to form well 59 that extends downwardly in to the $N^+$ layer 48. The mask *f* is then removed according to conventional techniques.

Referring to Figure 18G, the device is subjected to a silicon dioxide wet etch to remove the dioxide regions 57, 58. Thereafter, silicon dioxide is deposited to a thickness of 1200 nm so as to fill the wells 55, 56 and 59 with $SiO_2$. The upper surface is then subjected to CMP until the silicon nitride layer 54 is exposed.

Then, mask g from Figure 16 is applied and, the silicon dioxide in the wells 55, 56 and 59 is etched back until the well 59 is emptied, but leaving regions 60, 61 of $SiO_2$ in the wells 55, 56. The $SiO_2$ region 61 includes a pillar 62 formed by the mask *g*. The mask *g* is then removed.

Then, as shown in Figure 18H, silicon dioxide 33 is grown to a thickness of 5 nm on the exposed walls of the wells 55, 56 and 59.

Thereafter, a layer of $N^+$ polysilicon is deposited in regions 22, 63, 63'. The regions 22 form the gates of the transistors M2 for the individual memory cells. The photolithographic mask *h* is applied and the polysilicon 63 is subjected to a dry etch to achieve the configuration shown in Figure 18H.

Referring to Figure 18I, silicon dioxide 35 is deposited to a thickness of 1200 nm and then subjected to CMP until the silicon nitride surface 54 is re-exposed. The $S_iO_2$ is then etched back to achieve the configuration shown in Figure 18I.

Referring to Figure 18J, the silicon dioxide regions 33 are subject to a light wet etch and then an oxide layer of 5 nm thickness is grown on them. Thereafter, $P^+$ polysilicon 7, 64 ,64' is deposited to a thickness of 60 nm. If desired, alternate layers of $P^+$ polysilicon and $CoSi_2$ can be used to reduce the electrical resistance. The resulting layer or multi-layer is then subjected to a polysilicon dry etch to achieve the configuration of regions 7, 64 ,64'. The regions 7 provide the side gates for the NDRs of the individual cells.

In the next step shown in Figure 18K, mask *k* from Figure 16 is applied and the device is subjected to a silicon dry etch, after which the photoresist for the mask *k* is removed.

Silicon dioxide is then deposited to a thickness of 1200 nm and CMP is carried out until the silicon nitride surface 54 is re-exposed, so as to form the regions 36, 47. Thereafter, the device is subjected to a silicon nitride wet etch to remove the remaining portions of the layer 54.

Referring to Figure 18L, using the mask *l1* from Figure 16, the P and N-type layers 4, 2 are formed by boron 80 keV, $3x10^{13}cm^{-2}$ and phosphorous 80 keV, $3x10^{13}cm^{-2}$ implantation respectively, whereafter the mask is removed.

Referring to Figure 18M, the mask *m2* of Figure 16 is applied to the device and then an implantation process is carried out using boron to form the channel of the n-type transistor 31. The mask *m2* is then removed and replaced by mask *m3* shown in Figure 16. A corresponding implantation process is used to form the channel of the p-type transistor 32. The silicon dioxide layer 53 is removed by a light wet etch and silicon dioxide 53A of thickness 5nm is then grown.

A layer of polysilicon is deposited to a thickness of 100 nm, although layers of polysilicon and $CoSi_2$ can be used in order to reduce resistance, if required. Thereafter, a layer of silicon dioxide is deposited to a thickness of 100nm. Using photolithography, with mask *m1* shown in Figure 16, the gate regions are defined, using a $SiO_2$ and Si dry etch, so as to leave regions 44, 44' that comprise the individual gates of the transistors, overlaid by a layer of silicon dioxide 65, 65'. The mask *m1* is thereafter removed.

Referring to Figure 18N, the mask *n2* of Figure 16 is applied to the device and then an implantation process is carried out using arsenic to form lightly doped source and drain regions 20A, 21A for the n-type transistor 31. The mask *n2* is then removed and replaced by mask n3 shown in Figure 16. A corresponding implantation technique is used to form the lightly doped source and drain regions 20A', 21A' of p-type transistor 32. Then the mask *n3* is removed. Silicon dioxide is then deposited to a thickness of 60nm. A dry etch of the the deposited silicon dioxide is then carried out to leave silicon dioxide remaining along the sidewall of the gates 44 and 44'.

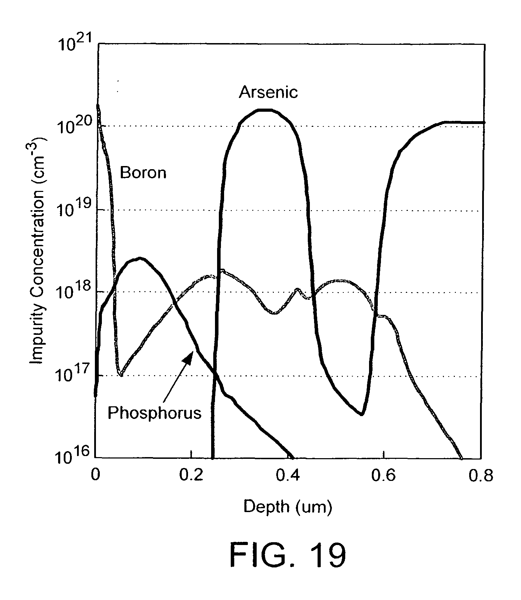

Then, as shown in Figure 18O, the silicon dioxide layer 38 is deposited to a thickness of 500 nm over the entire device. Using photolithography with mask o shown in Figure 16, and a dry etch, vias 37, 66, 67, 68, 67' and 68" are formed. Thereafter, the photoresist mask is removed. Then, metal interconnections are formed through the vias to establish the various word and bit lines. Figure 19 shows the impurity profile in the layers 1, 2, 3, 4, 5, 19, 20 and 21.

The resulting SRAM can provide 1Gb of the memory within a memory cell array of the order of 1 $cm^2$ using 0.13 micron lithography. The device has a standby current of 10 microamperes and an access time of 5 nanoseconds. The device is thus suited to mobile devices where low power consumption is required. The invention is thus particularly applicable to third generation mobile devices which require a high memory capacity, small occupation area and high speed access for handling pictures and movies.

One of the advantages of the device described with reference to Figures 16 - 18 is that the memory cells $M_{ij}$ and the CMOS transistors 31, 32 have a generally similar height on the substrate 29 and so are capable of being integrated into a LSI chip with integrated memory and logic functions. The device shown in Figures 16 and 17 has a planar upper surface which extends across both the memory cell array $M_{ij}$ and the CMOS transistors 31, 32.

Also, the fabrication process can readily provide electrical connections between the memory cell array $M_{ij}$ and the CMOS transistors 31, 32. It will be noted that the fabrication process gives rise to N-type conductive polysilicon regions 63, and P-type conductive regions 64 which are at different heights and extend both vertically and horizontally. Thus, it will be understood that by configuring the masks used durng manufacture, these regions can form appropriate connections at different levels and in different directions between the memory cell array and the components of the peripheral circuits, including transistors such as CMOS devices 31, 32.

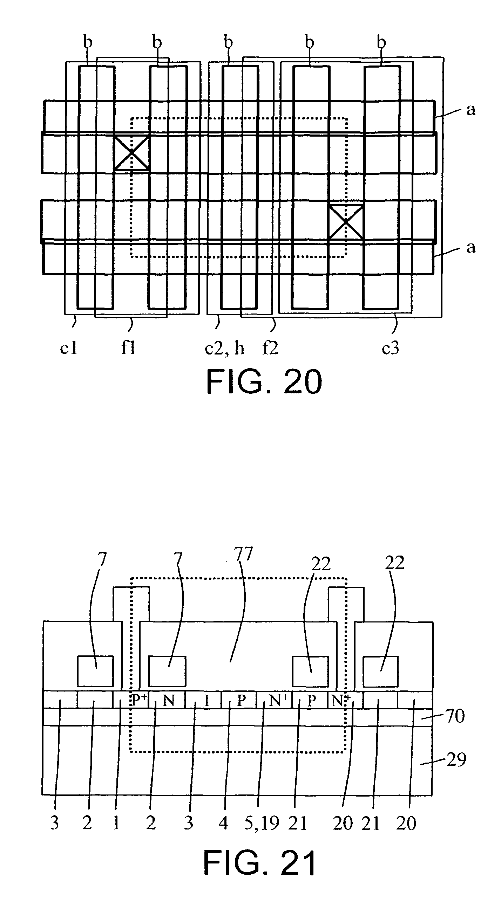

Another example of memory cell array according to the invention will now be described with reference to Figures 20, 21, and 22. Like parts to those of the embodiment of Fig. 1 to 18 and annotated with the same reference numbers. In this example of the memory cell array, the NDR and MOS transistor M2 are arranged in a planar configuration in a SOI (Silicon on Insulator) substrate. By using a SOI substrate, isolation regions can be reduced between the various P, N, I, P, N, (regions 1 - 5) the channel and N regions 21, 20, so reducing the size of each memory cell. The planar structure can be fabricated more simply than in the previously described vertical structures, and the widths and concentrations of the P, N, I, P, N, channel and N regions can be easily changed during the design process.

Figure 20 illustrates the memory cell array in plan view and outlines masks *a - f* that are used during the fabrication process. Figure 21 is a sectional view of the device shown in Figure 20. An individual cell of the array is shown in dotted outline in both of the Figures.

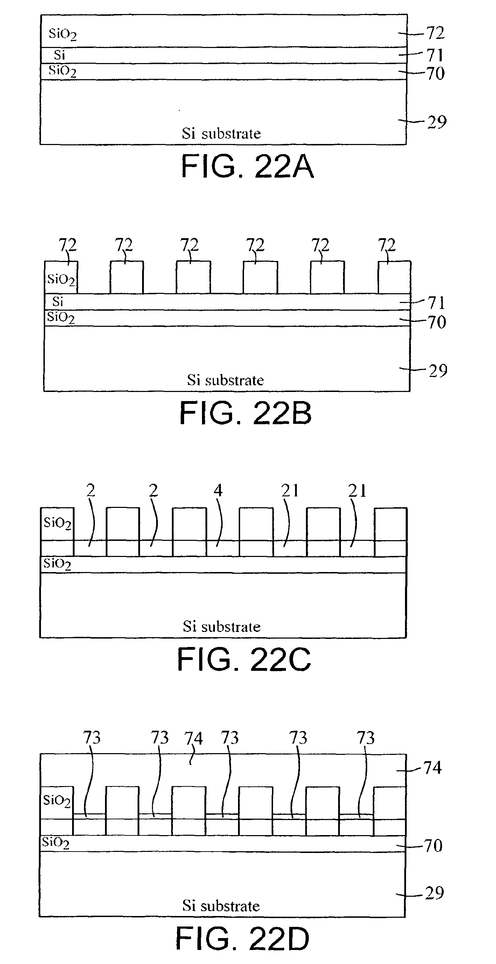

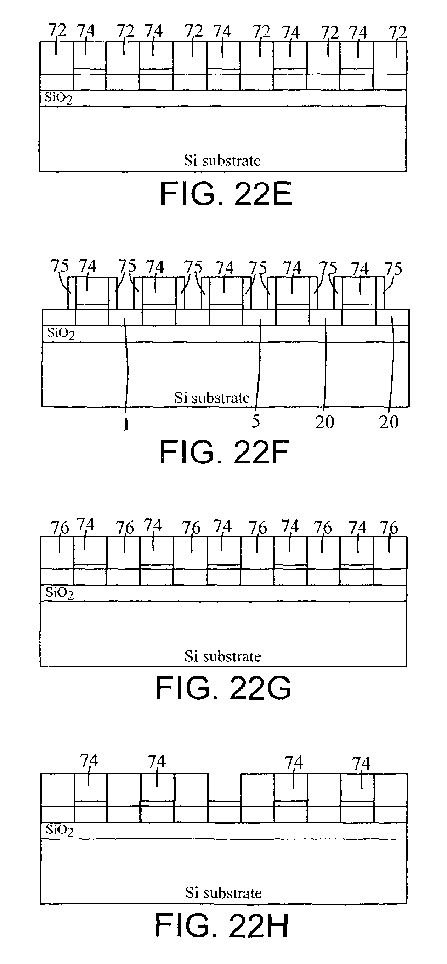

Fabrication of the device of Figure 21 will now be described with reference to Figure 22. In this embodiment, 0.2um line/space lithography techniques are used.

As shown in Figure 22A, SOI substrate 29 with 100nm thick silicon dioxide layer 70 and 100nm thick silicon layer 71 is used. By using conventional techniques, isolation regions formed by mask *a* in Figure 20, are formed (not shown in Fig. 22). Thereafter, a silicon dioxide layer 72 is deposited to a thickness 200nm.

Referring to Figure 22B, the mask *b* shown in Figure 20 is applied to the surface of the device and a dry etching of the silicon dioxide 72 is carried out. The mask *b* is then removed according to conventional techniques.

Referring to Figure 22C, using the mask *c1* from Figure 20, N-type region 2 is formed through mask *c1* by phosphorus implantation 50keV, $5\times10^{12}$ $cm^{-2}$. The mask *c1* is then removed and replaced by mask *c2* shown in Figure 20. P-type region 4 is formed through mask *c2* by $BF_2$ implantation 60keV, $10^{14}$ $cm^{-2}$. The mask *c2* is then removed and replaced by mask *c3* shown in Figure 20. P-type channel region 21 is formed through mask *c3* by boron implantation 30keV, $3\times10^{13}$ $cm^{-2}$. The mask *c3* is then removed.

Referring to Figure 22D, silicon dioxide 73 is grown to a thickness of 5nm. TiN 74 is deposited to a thickness 200nm.

Referring to Figure 22E, TiN 74 is etched back until the surface of the silicon dioxide layer 72 appears.

Referring to Figure 22F, the silicon dioxide layer 72 is removed by dry etching. Then a silicon dioxide layer 75 of thickness 30nm is deposited and dry etched so as to remain solely along the sidewalls of the TiN regions 74. Using the mask *f1* from Figure 20, heavily doped P-type region 1 is formed through the mask *f1* by $BF_2$ implantation - 80keV,

$2x10^{16}$ cm$^{-2}$. The mask *f1* is then removed and replaced by mask *f2* shown in Figure 20. Heavily doped N-type region 20 is formed by arsenic implantation 60keV, $10^{16}$ cm$^{-2}$ through the mask *f2*, which is then removed.

Referring to Figure 22G, a layer of silicon dioxide 76 is deposited to a thickness 200nm and etched back to expose the surface of the TiN regions 74.

Referring to Figure 22H, the mask *h* shown in Figure 20 is applied to the surface of the device and 6 a dry etching process is carried out on the TiN 74. The mask *h* is then removed according to conventional techniques.

Referring to back to Figure 21, an overlying layer of silicon dioxide 77 is then deposited, in which contact holes 78 are formed and filled with metal 79, and metal is deposited and patterned to establish the various word and bit lines, including lines 7 and 22 shown in the Figure.

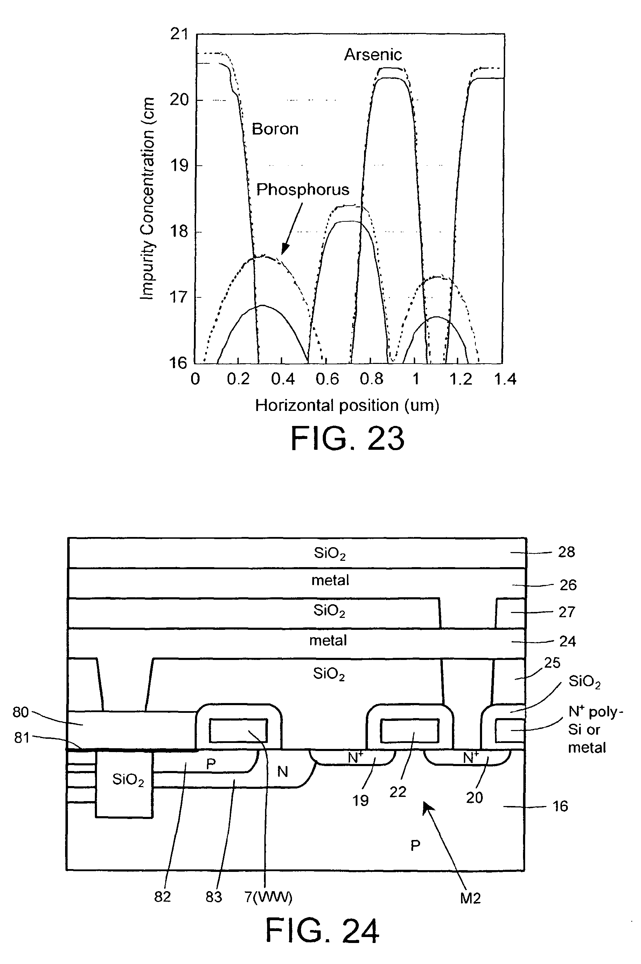

The impurity profile for the resulting device is shown in Figure 23. Straight lines correspond to the top of silicon layer and dotted lines correspond to the bottom of silicon layer. The impurity concentrations at the top of silicon layer are lower than the bottom concentrations. These are designed so as to control the NDR and MOS transistor by gates strongly at the top surface, and the NDR tends to take the negative resistance state and the MOS transistor tends to take the OFF state towards the bottom from the top, since gate control becomes weak.

In this example, a TiN gate is used but different gate materials can be used also. The ion implantation conditions vary in dependence upon the work function of gate material. The conditions are summarized in Table 1 for mid-gap material, P$^+$ - polycrystalline silicon, N$^+$ - polycrystalline silicon gate materials.

Table 1. Ion Implantation Conditions for different gate materials

| gate material | N region | P region | MOS channel |
|---|---|---|---|
| mid-gap (TiN, etc) | $5x10^{12}$ P cm$^{-2}$ 50keV | $10^{14}$ BF$_2$ cm$^{-2}$ 60keV | $3x10^{13}$ B cm$^{-2}$ 30keV |
| P$^+$ polySi | $10^{13}$ P cm$^{-2}$ 20keV | $5x10^{13}$ BF$_2$ cm$^{-2}$ 40keV | $5x10^{13}$ B cm$^{-2}$ 20keV<br>$5.3x10^{13}$ As cm$^{-2}$ 20keV |
| N$^+$ polySi | $10^{12}$ P cm$^{-2}$ 50keV | $10^{14}$ BF$_2$ cm$^{-2}$ 40keV | $1.9x10^{14}$ B cm$^{-2}$ 20keV |

Many modifications and variations of the described device fall within the scope of the invention. For example the gate 7 of the thyristor can contact the N type region 2 directly rather than being spaced by the insulator 6.

Also, other NDR devices can be used and Figure 24 illustrates an example in which a MISFET (Metal Insulator Silicon Field Effect Transistor) is used as a NDR. The arrangement can be considered as a modification of the arrangement of Figure 15 in which, instead of using a thyristor, NDR characteristics are obtained in a MISFET comprising poly-Si or metal layer 80, tunnel insulator 81, P-type silicon region 82, N-type silicon layer 83 and gate 7. The carrier states in the P-type region 82 can be modulated by the gate 7. The MISFET is connected to transistor M2 as shown.

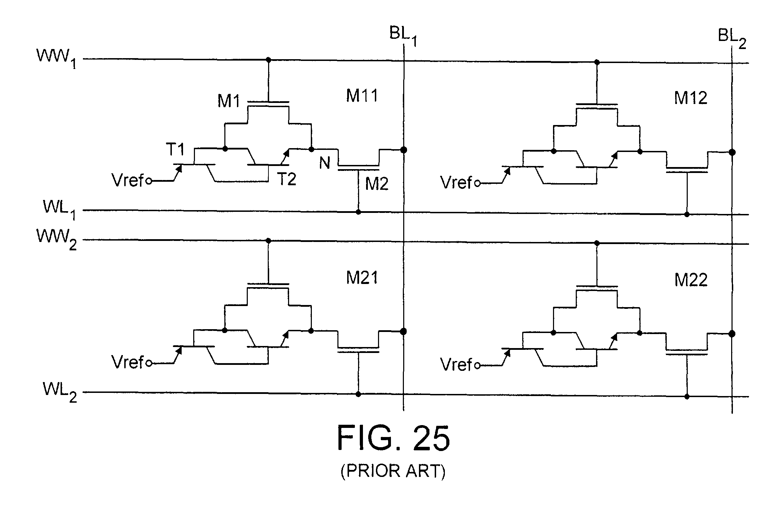

The operational advantage of a the described memory cell array according to the invention will be made clear from the following discussion of a prior cell array that uses a NDR device in each memory cell. Schematic circuitry of a 2 x 2 memory cell array of gated thyristor SRAM is shown in Figure 25 as an example from US patent US-A-6 229 161 *supra*. In this configuration, when data is written to $M_{11}$, a voltage corresponding to "0" or "1" is supplied to BL1, the voltage on WL1 is set so that the MOSFET of $M_{11}$ is in an ON state, and voltage on WW1 is set so that the thyristor of $M_{11}$ has p-n diode characteristics. However, in this case, thyristor of $M_{12}$ has also p-n diode characteristics and the MOSFET of $M_{12}$ is also in the ON state, and so the data stored on $M_{12}$ is destroyed. To avoid the lost of data, data on $M_{12}$ must be read on BL2 and re-written in the write cycle. Since the voltage detected on BL2 is not sufficient to re-write the data, amplification of detected signal is required outside the memory cell. Furthermore, a signal of opposite polarity to that of the written voltage is detected, and so the peripheral circuits need to carry out both inversion and amplification and therefore are complex and take up a significant amount of space on the substrate.

**Claims**

1. A memory device including an array of memory cells ($M_{ij}$) each comprising a memory node (N) and a NDR device (NDR) operable in first mode with a negative differential resistance characteristic which causes first and second different memory states written to the cell to be maintained at the node, and in a second mode without said negative differential resistance, and peripheral circuitry (13,14) for the array operable to read data from and write data to the cells, the peripheral circuitry being coupled to a plurality of bit and word lines (BL,BW,WL,WW) connected to supply voltage signals to each memory cell, and the peripheral circuitry being operable to write data by changing the NDR device of one of the cells from its first mode to the second mode, setting the memory state of the node whilst the NDR is in said second mode and thereafter changing the NDR to the first mode to maintain the set memory state at the node, wherein the voltage signals control the mode of the NDR device of each memory cell and the bit and word lines are operable to supply the voltage signals to the memory cells to change the NDRs of the memory cells to the second mode for the writing of data, each cell in the array being coupled to a first word line (WL), a second word line (WW) and a first bit line (BL), the NDR of each cell comprising a capacitively-coupled gate (M1) arranged to respond to the second word line (WW), **characterised in that** each cell in the array is further coupled to a second bit line (BW), the NDR of each cell comprising a current conduction path connected between the second bit line (BW) and the memory node (N) of the cell so as to receive signals from the second word line (WW) and the second bit line (BW) to control the mode of the NDR and to change the mode of the NDR to the second mode, without changing the mode of the NDR in any of the other memory cells so as to maintain the memory states of the nodes thereof during the writing of the data.

2. A memory device according to claim 1 wherein the first bit line (BL) is for exchanging data between inner and outer memory cell arrays, the first word line (WL) and second bit (BW) line are for reading and writing data, and the second word (WW) line is for selecting read or write operation, wherein the second bit line comprises a write bit line and the second word line comprises a write word line.

3. A memory device according to claim 2 wherein the cells are arranged in a two dimensional array (m x n) of rows and columns, with a plurality of the bit lines, word lines, write bit lines and write word lines being arrayed in rows and columns for the cells, and the peripheral circuitry (13,14) being operable to energise the write bit lines (BW) and word lines (WL) individually so as to select an individual one of the cells to have data read from or written thereto.

4. A memory device according to claim 3 wherein the peripheral circuits (13,14) are configured to apply enabling voltages (BWH, WWL) to the write bit lines (BW) and write word (WW) lines for a particular row and column of the array, the voltages being sufficient to cooperate and switch the NDR device of the cell at the intersection of the row and column into said second mode, but being insufficient to switch into the second mode the NDR devices of other ones of the cells that lie in the row and the column that are subject to the enabling voltages.

5. A memory device according to claim 4 wherein to write data, the peripheral circuits (13,14) are configured to apply a relatively high voltage (BWH) to the second bit line (BW) and, to write data corresponding to a first of the memory states, a relatively high voltage (BLH) to the first bit line (BL) whereas to write data corresponding to a second of the memory states peripheral circuits (13, 14) are configured to apply a relatively low voltage (BLL) to the first bit line (BL)

6. A memory device according to claim 4 or 5 wherein each of the cells ($M_{ij}$) includes a switching device (M2) having a switchable conduction path coupled to the node (N) and a gate for switching the conductivity of the path, the gate being coupled to the first word line (WL) for the cell, the peripheral circuits (13,14) being operable to write data to and read data from one of the cells by applying a voltage (WLH) to the first word line for the cell so as to switch said path to a conductive state.

7. A memory device according to claim 6 wherein to write data, the peripheral circuits (13,14) are configured to apply a relatively high or low (BLH, BLL) voltage corresponding to the first and second memory states to the first bit line for the cell concerned, and to read data the peripheral circuits (13,14) are configured to sense a relatively high or low voltage corresponding to the stored memory states for the cell concerned from the first bit line for the cell.

8. A memory device according to claim 7 including a common input/output line (I/O) coupled to the first bit lines (BL) to receive data to be written to the cells ($M_{ij}$) and data read from the cells.

9. A memory device according to claim 8 including pass gates (YS) coupling the first bit lines (BL) to the input/output line (I/O).

10. A memory device according to any one of claims 6 to 9 wherein the switching device comprises a MOSFET.

11. A memory device according to any one of claims 6 to 10 wherein the switching device comprises a vertical transistor.

12. A memory device according to claim any one of claims 6 to 11 wherein for at least some of the cells ($M_{ij}$), the switching device (M2) and the NDR device (NDR) overlie one another.

13. A memory device according to any preceding claim wherein the NDR comprises layers (1-5) of semiconductor material with different conductivity characteristics.

14. A memory device according to claim 13 wherein the NDR device comprises a thyristor (NDR) and the gate is for switching the conductive characteristics thereof between the first and second modes.

15. A memory device according to any preceding claim wherein the NDR device comprises a MISFET.

16. A memory device according to claim 13 or 14 wherein the layers (1-5) are disposed vertically in an overlying relationship.

17. A memory device according to claim 13 or 14 wherein the layers (1-5) are disposed horizontally.

18. A memory device according to claim 17 wherein the NDR device is formed on a SOI substrate

19. A memory device according to any preceding claim wherein the memory cells ($M_{ij}$) and the peripheral circuits (13,14) are formed on a common substrate (16, 29).

20. A memory device according to claim 19 wherein the peripheral circuits include complementary transistors (31, 32) formed in the substrate.

21. A memory device according to claim 20 wherein the transistors (31, 32) comprise CMOS transistors.

22. A memory device according to claim 21 wherein the CMOS transistors (31, 32) and the memory cells ($M_{ij}$) have substantially the same height on the substrate.

23. A memory device according to claim 1, each memory cell comprising:

   a transistor (M2), the gate of the transistor being configured and arranged to respond to the first word line (WL), and the source and drain of the transistor being connected to the first bit line (BL) and the memory node (N), wherein the memory cell is configured so that when selection signals are applied to both the second word line (WW) and the second bit line (BW), the NDR device is switched to current-pass mode but otherwise, the NDR device is in current-blocked mode.

24. A memory device according to claim 1, each memory cell comprising:

   a first semiconducting region heavily doped with either p-type or n-type conduction type,
   a second region doped with the opposite conduction type to the first region, and contacted to the first region
   a third region lightly doped with either p-type or n-type conduction type or non-doped, and contacted to the second region
   a fourth region doped with the same conduction type as the first region, contacted to the third region
   a fifth region heavily doped with the opposite conduction type to the first region, contacted to the forth region, wherein the gate contacts at least a part of the surface of the second region through an insulator.

25. The memory device of claim 24 wherein the doping concentration of the third region is less than $10^{18}$ cm$^{-3}$.


**Patentansprüche**

1. Speichervorrichtung, aufweisend ein Feld von Speicherzellen ($M_{ij}$), die jede einen Speicherknoten (N) und eine NDR-Vorrichtung (NDR) umfassen, welche in einem ersten Modus mit einer negativen Differentialwiderstandscharakteristik, welche verursacht, dass unterschiedliche auf die Zelle geschriebene erste und zweite Speicherzustände am Knoten aufrechterhalten werden, und in einem zweiten Modus ohne den negativen Differentiaiwiderstand betriebsfähig ist, und einen peripheren Schaltkreis (13, 14) für das Feld, der zum Lesen von Daten aus und Schreiben von Daten in die Zellen betriebsfähig ist, wobei der periphere Schaltkreis an eine Mehrzahl von Bit- und Wortleitungen (BL, BW, WL, WW) gekoppelt ist, die angeschlossen sind, um Spannungssignale an jede Speicherzelle zuzuführen, und der periphere Schaltkreis betriebsfähig ist, Daten durch Ändern der NDR-Vorrichtung von einer der Zellen von ihrem ersten Modus in den zweiten Modus zu schreiben, den Speicherzustand des Knotens einzustellen, während die NDR im zweiten Modus ist, und danach die NDR zum ersten Modus zu ändern, um den eingestellten Speicherzustand des Knotens aufrechtzuerhalten, wobei das Spannungssignal den Modus der NDR-Vorrichtung von jeder Speicherzelle steuert und die Bit- und Wortleitungen betriebsfähig sind, die Spannungssignale an die Speicherzellen zuzuführen, um die NDR der Speicherzellen in den zweiten Modus für das Schreiben von Daten zu ändern, wobei jede Zelle in dem Feld an eine erste Wortleitung (WL), eine zweite Wortleitung (WW) und eine erste Bitleitung (BL) gekoppelt ist, wobei die NDR jeder Zelle ein kapazitiv-gekoppeltes Gate (M1) umfasst, das dazu angeordnet ist, auf die zweite Wortleitung (WW) zu antworten, **dadurch gekennzeichnet, dass** jede Zelle in dem Feld ferner an eine zweite Bitleitung (BL) gekoppelt ist, wobei die NDR jeder Zelle einen Strom-Leitungspfad umfasst, welcher zwischen der zweiten Bitleitung (BW) und dem Speicherknoten (N) der Zelle angeschlossen ist, um Signale von der zweiten Wortleitung (WW) und der zweiten Bitleitung (BW) zu empfangen, um den Modus der NDR zu steuern und den Modus der NDR in den zweiten Modus zu ändern, ohne Ändern des Modus der NDR in irgendeiner der anderen der Speicherzellen, um die Speicherzustände von deren Knoten während des Schreibens der Daten aufrechtzuerhalten.

2.   Speichervorrichtung nach Anspruch 1, wobei die erste Bitleitung (BL) zum Austauschen von Daten zwischen inneren und äußeren Speicherzellenfeldern dient, die erste Wortleitung (WL) und zweite Bitleitung (BW) zum Lesen und Schreiben von Daten dient, und die zweite Wortleitung (WW) zum Auswählen einer Lese- oder Schreiboperation dient, wobei die zweite Bitleitung eine Schreibbitleitung umfasst und die zweite Wortleitung eine Schreibwortleitung umfasst.

3.   Speichervorrichtung nach Anspruch 2, wobei die Zellen in einem zweidimensionalen Feld (m x n) von Zeilen und Spalten mit einer Mehrzahl von Bitleitungen, Wortleitungen, Schreibbitleitungen und Schreibwortleitungen angeordnet sind, die in Reihen und Spalten für die Zellen angeordnet sind, und der periphere Schaltkreis (13, 14) betriebsfähig ist, die Schreibbitleitungen (BW) und Wortleitungen (WL) einzeln einzuschalten, um eine einzelne der Zellen auszuwählen, um Daten davon zu lesen oder darauf zu schreiben.

4.   Speichervorrichtung nach Anspruch 3, wobei die peripheren Schaltungen (13, 14) dazu eingerichtet sind, Freigabe-Spannungen (BWH, WWL) an die Schreibbitleitungen (BW) und Schreibwortleitungen (WW) für eine bestimmte Zeile und Spalte des Feldes anzulegen, wobei die Spannungen ausreichend sind, zusammenzuwirken und die NDR-Vorrichtung der Zelle an der Kreuzung der Zeile und Spalte in den zweiten Modus zu schalten, aber nicht ausreichend sind, die NDR-Vorrichtungen von anderen der Zellen in den zweiten Modus zu schalten, die in der Zeile und der Spalte liegen, die den Freigabe-Spannungen unterliegen.

5.   Speichervorrichtung nach Anspruch 4, wobei, um Daten zu schreiben, die peripheren Schaltungen (13, 14) dazu eingerichtet sind, eine relativ hohe Spannung (BWH) an die zweite Bitleitung (BW) und, um Daten ensprechend einem ersten der Speicherzustände zu schreiben, eine relativ hohe Spannung (BLH) an die erste Bitleitung (BL) anzulegen, wohingegen, um Daten entsprechend einem zweiten der Speicherzustände zu schreiben, die peripheren Schaltungen (13, 14) dazu eingerichtet sind, eine relativ niedrige Spannung (BLL) an die erste Bitleitung (BL) anzulegen.

6.   Speichervorrichtung nach Anspruch 4 oder 5, wobei jede der Zellen ($M_{ij}$) eine Schaltvorrichtung (M2) aufweist, die einen an den Knoten (N) gekoppelten schaltbaren Leitungspfad und ein Gate zum Schalten der Leitfähigkeit des Pfades hat, wobei das Gate an die erste Wortleitung (WL) der Zelle gekoppelt ist, wobei die peripheren Schaltungen (13, 14) betriebsfähig sind, Daten auf und Daten von einer der Zellen durch Anlegen einer Spannung (WLH) an die erste Wortleitung der Zelle zu schreiben und zu lesen, um den Pfad in einen leitenden Zustand zu schalten.

7.   Speichervorrichtung nach Anspruch 6, wobei, um Daten zu schreiben, die peripheren Schaltungen (13, 14) dazu eingerichtet sind, eine relativ hohe oder niedrige Spannung (BLH, BLL) entsprechend dem ersten und zweiten Speicherzustand an die erste Bitleitung der betreffenden Zelle anzulegen, und, um Daten zu lesen, die peripheren Schaltungen (13, 14) dazu eingerichtet sind, eine relativ hohe oder niedrige Spannung entsprechend dem gespeicherten Speicherzustand für die betreffende Zelle aus der ersten Bitleitung der Zelle zu lesen.

8.   Speichervorrichtung nach Anspruch 7, das eine gemeinsame Eingabe/Ausgabe-Leitung (I/O) aufweist, die an die ersten Bitleitungen (BL) gekoppelt ist, um Daten, die auf die Zellen ($M_{ij}$) zu schreiben sind, und Daten, die aus den Zellen gelesen wurden, zu empfangen

9.   Speichervorrichtung nach Anspruch 8, das Durchgangsgates (YS) aufweist, welche die ersten Bitleitungen (BL) an die Eingabe/Ausgabe-Leitung (I/O) koppeln.

10. Speichervorrichtung nach einem der Ansprüche 6 bis 9, wobei die Schaltvorrichtung einen MOSFET umfasst.

11. Speichervorrichtung nach einem der Ansprüche 6 bis 10, wobei die Speichervorrichtung einen vertikalen Transistor umfasst.

12. Speichervorrichtung nach einem der Ansprüche 6 bis 11, wobei sich für zumindest einige der Zellen ($M_{ij}$) die Schaltvorrichtung (M2) und die NDR-Vorrichtung (NDR) einander überlagern.

13. Speichervorrichtung nach einem der vorhergehenden Ansprüche, wobei die NDR Schichten (1 - 5) von Halbleitermaterial mit unterschiedlichen Leitfähigkeitscharakteristiken umfasst.

14. Speichervorrichtung nach Anspruch 13, wobei die NDR-Vorrichtung einen Thyristor (NDR) umfasst, und das Gate zum Schalten der leitenden Charakteristiken davon zwischen dem ersten und zweiten Modus dient.

15. Speichervorrichtung nach einem der vorhergehenden Ansprüche, wobei die NDR-Vorrichtung einen MISFET umfasst.

16. Speichervorrichtung nach Anspruch 13 oder 14, wobei die Schichten (1 - 5) in einer überlagernden Beziehung vertikal angeordnet sind.

17. Speichervorrichtung nach Anspruch 13 oder 14, wobei die Schichten (1 - 5) horizontal angeordnet sind.

18. Speichervorrichtung nach Anspruch 17, wobei die NDR-Vorrichtung auf einem SOI-Substrat gebildet ist.

19. Speichervorrichtung nach einem der vorhergehenden Ansprüche, wobei die Speicherzellen ($M_{ij}$) und die peripheren Schaltungen (13, 14) auf einem gemeinsamen Substrat (16, 29) gebildet sind.

20. Speichervorrichtung nach Anspruch 19, wobei die peripheren Schaltungen komplementäre Transistoren (31, 32) aufweisen, die in dem Substrat gebildet sind.

21. Speichervorrichtung nach Anspruch 20, wobei die Transistoren (31, 32) CMOS-Transistoren umfassen.

22. Speichervorrichtung nach Anspruch 21, wobei die CMOS-Transistoren (31, 32) und die Speicherzellen ($M_{ij}$) im Wesentlichen die gleiche Höhe auf dem Substrate haben.

23. Speichervorrichtung nach Anspruch 1, wobei jede Speicherzelle umfasst:

   einen Transistor (M2), wobei das Gate des Transistors dazu eingerichtet und angeordnet ist, auf die erste Wortleitung (WL) zu antworten, und die Source und Drain des Transistors an die erste Bitleitung (BL) und den Speicherknoten (N) angeschlossen ist, wobei die Speicherzelle so eingerichtet ist, dass, wenn Auswahlsignale an die zweite Wortleitung (WW) und die zweite Bitleitung (BW) angelegt werden, die NDR-Vorrichtung zum Strom-Durchgangsmodus geschaltet wird und andernfalls die NDR-Vorrichtung im Strom-Blockiermodus ist.

24. Speichervorrichtung nach Anspruch 1, wobei jede Speicherzelle umfasst:

   einen ersten halbleitenden Bereich, der entweder mit einem P-Typ oder N-Typ-Leitungstyp stark dotiert ist,
   einen zweiten Bereich, der mit dem zum ersten Bereich entgegengesetzten Leitungstyp dotiert ist, und den ersten Bereich berührt,
   einen dritten Bereich, der entweder mit einem P-Typ oder N-Typ-Leitungstyp schwach dotiert oder nicht dotiert ist, und den zweiten Bereich berührt,
   einen vierten Bereich, der mit dem gleichen Leitungstyp wie der erste Bereich dotiert ist, der den dritten Bereich berührt,
   einen fünften Bereich, der mit dem zum ersten Bereich entgegengesetzten Leitungstyp stark dotiert ist, der den vierten Bereich berührt,
   wobei das Gate zumindest einen Teil der Oberfläche des zweiten Bereiches durch einen Isolator berührt.

25. Speichervorrichtung nach Anspruch 24, wobei die Dotierungskonzentration des dritten Bereiches geringer als $10^{18}$ cm$^{-3}$ ist.

**Revendications**

1. Dispositif de mémoire comportant un réseau de cellules de mémoire ($M_{ij}$) comportant chacune un noeud de mémoire (N) et un dispositif NDR (NDR) exploitable dans un premier mode avec une caractéristique de résistance différentielle négative qui occasionne le maintien au niveau du noeud des premier et second états de mémoire différents écrits dans la cellule, et dans un second mode sans ladite résistance différentielle négative, et un montage de circuits périphériques (13, 14) pour le réseau, exploitable pour lire des données à partir des, et écrire des données dans les cellules, le montage de circuits périphériques étant couplé à une pluralité de lignes de mots et de bits (BL, BW, WL, WW) connectées à des signaux de tension d'alimentation à chaque cellule de mémoire, et le montage de circuits périphériques étant exploitable pour écrire des données en commutant le dispositif NDR de l'une des cellules de son premier mode au second mode, pour régler l'état de mémoire du noeud alors que le NDR est dans ledit second mode et ensuite pour passer le dispositif NDR au premier mode pour maintenir l'état de mémoire réglé au noeud, dans lequel les signaux de tension commandent le mode du dispositif NDR de chaque cellule de mémoire et les lignes de mots et de bits sont exploitables pour fournir les signaux de tension aux cellules de mémoire pour passer les NDR des cellules de mémoire au second mode pour l'écriture de données, chaque cellule dans le réseau étant couplée à une première ligne de mots (WL), à une seconde ligne de mots (WW) et à une première ligne de bits (BL), le dispositif de lecture non destructive (NDR) de chaque cellule comprenant une grille couplée de manière capacitive (M1) agencée pour répondre à la seconde ligne de mots (WW),
   **caractérisé en ce que** chaque cellule dans le réseau est en outre couplée à une seconde ligne de bits (BW), le dispositif NDR de chaque cellule comportant un chemin de conduction de courant connecté entre la seconde ligne de bits (BW) et le noeud de mémoire (N) de la cellule afin de recevoir des signaux de la seconde ligne de mots (WW) et de la seconde ligne de bits (BW) pour commander le mode du NDR et pour passer le mode du NDR au second mode, sans changer le mode du NDR dans l'une quelconque des autres cellules de mémoire de façon à maintenir les états de mémoire des noeuds lors de l'écriture des données.

2. Dispositif de mémoire selon la revendication 1, dans lequel la première ligne de bits (BL) est destinée à échanger des données entre des réseaux de cellules de mémoire internes et externes, la première ligne de mots (WL) et la seconde ligne de bits (BW) sont destinées à lire et écrire des données, et la seconde ligne de mots (WW) est destinée à sélectionner une opération de lecture ou d'écriture, où la seconde ligne de bits comporte une ligne de bits d'écriture et la seconde ligne de mots comporte une ligne de mots d'écriture.

3. Dispositif de mémoire selon la revendication 2, dans lequel les cellules sont agencées dans un réseau à deux dimensions (m x n) de rangées et de colonnes, où une pluralité des lignes de bits, des lignes de mots, des lignes de bits d'écriture et des lignes de mots d'écriture est agencée en réseau, en rangées et colonnes, pour les cellules, et le montage de circuits périphériques (13, 14) est exploitable pour alimenter les lignes de bits d'écriture (BW) et lignes de mots d'écriture (WL) individuellement de façon à sélectionner une cellule individuelle parmi les cellules en tant qu'ayant des données lues à partir de celle-ci ou écrites dans celle-ci.

4. Dispositif de mémoire selon la revendication 3, dans lequel les circuits périphériques (13, 14) sont configurés pour appliquer des tensions d'activation (BWH, WWL) aux lignes de bits d'écriture (BW) et aux lignes de mots d'écriture (WW) pour une rangée et colonne particulières du réseau, les tensions étant suffisantes pour faire coopérer et commuter le dispositif NDR de la cellule à l'intersection de la rangée et de la colonne dans ledit second mode, mais étant insuffisantes pour faire commuter dans ledit second mode les dispositifs NDR d'autres cellules parmi les cellules qui se trouvent dans la rangée et dans la colonne qui sont soumises aux tension d'activation.

5. Dispositif de mémoire selon la revendication 4, dans lequel pour écrire des données, les circuits périphériques (13, 14) sont configurés pour appliquer une tension relativement haute (BWH) à la seconde ligne de bits (BW) et, pour écrire des données correspondant à un premier des états de mémoire, pour appliquer une tension relativement haute (BLH) à la première ligne de bits (BL), tandis que pour écrire des données correspondant à un second des états de mémoire, les circuits périphériques (13, 14) sont configurés pour appliquer une tension relativement basse (BLL) à la première ligne de bits (BL).

6. Dispositif de mémoire selon la revendication 4 ou 5 dans lequel chacune des cellules ($M_{ij}$) comporte un dispositif de commutation (M2) ayant un chemin de conduction commutable couplé au noeud (N) et une grille pour commuter la conductivité du chemin, la grille étant couplée à la première ligne de mots (WL) pour la cellule, les circuits périphériques (13, 14) étant exploitables pour écrire des données vers et pour lire les données à partir d'une des cellules en appliquant une tension (WLH) à la première ligne de mots de la cellule afin de commuter ledit chemin vers un état conducteur.

**7.** Dispositif de mémoire selon la revendication 6, dans lequel, pour écrire des données, les circuits périphériques (13, 14) sont configurés pour appliquer une tension relativement haute ou basse (BLH, BLL) correspondant aux premier et second états de mémoire à la première ligne de bits de la cellule concernée, et pour lire des données, les circuits périphériques (13, 14) sont configurés pour détecter une tension relativement haute ou basse correspondant aux états de mémoire stockés de la cellule concernée à partir de la première ligne de bits de la cellule.

**8.** Dispositif de mémoire selon la revendication 7, comportant une ligne d'entrée/sortie (E/S) commune couplée aux premières lignes de bits (BL) pour recevoir des données à écrire dans les cellules ($M_{ij}$) et des données lues à partir des cellules.

**9.** Dispositif de mémoire selon la revendication 8, comportant des grilles de transit (YS) couplant les premières lignes de bits (BL) à la ligne d'entrée/sortie (E/S).

**10.** Dispositif de mémoire selon l'une quelconque des revendications 6 à 9, dans lequel le dispositif de commutation comporte un transistor à effet de champ de semi-conducteur d'oxyde de métal (MOSFET).

**11.** Dispositif de mémoire selon l'une quelconque des revendications 6 à 10, dans lequel le dispositif de commutation comporte un transistor vertical.

**12.** Dispositif de mémoire selon l'une quelconque des revendications 6 à 11, dans lequel pour au moins certaines des cellules ($M_{ij}$), le dispositif de commutation (M2) et le dispositif NDR (NDR) se chevauchent mutuellement.

**13.** Dispositif de mémoire selon l'une quelconque des revendications précédentes dans lequel le dispositif NDR comporte des couches (1 - 5) de matériau semi-conducteur avec différentes caractéristiques de conductivité.

**14.** Dispositif de mémoire selon la revendication 13, dans lequel le dispositif NDR comporte un thyristor (NDR) et la grille sert à commuter les caractéristiques conductrices de celui-ci entre les premier et second modes.

**15.** Dispositif de mémoire selon l'une quelconque des revendications précédentes dans lequel le dispositif NDR comporte un transistor à effet de champ à isolateur métallique (MISFET).

**16.** Dispositif de mémoire selon la revendication 13 ou 14, dans lequel les couches (1 - 5) sont agencées verticalement dans une relation de chevauchement.

**17.** Dispositif de mémoire selon la revendication 13 ou 14 dans lequel les couches (1 - 5) sont agencées horizontalement.

**18.** Dispositif de mémoire selon la revendication 17, dans lequel le dispositif NDR est formé sur un substrat de silicium sur isolant (SOI).

**19.** Dispositif de mémoire selon l'une quelconque des revendications précédentes, dans lequel les cellules de mémoire ($M_{ij}$) et les circuits périphériques (13, 14) sont formés sur un substrat commun (16, 29).

**20.** Dispositif de mémoire selon la revendication 19, dans lequel les circuits périphériques comportent des transistors complémentaires (31, 32) formés dans le substrat.

**21.** Dispositif de mémoire selon la revendication 20, dans lequel les transistors (31, 32) comportent des transistors à semi-conducteur à oxyde de métal complémentaire (CMOS).

**22.** Dispositif de mémoire selon la revendication 21, dans lequel les transistors CMOS (31, 32) et les cellules de mémoire ($M_{ij}$) ont sensiblement la même hauteur sur le substrat.

**23.** Dispositif de mémoire selon la revendication 1, chaque cellule de mémoire comprenant :

un transistor (M2), la grille du transistor étant configurée et agencée pour répondre à la première ligne de mots (WL), et la source et le drain du transistor étant connectés à la première ligne de bits (BL) et au noeud de mémoire (N), dans lequel la cellule de mémoire est configurée de sorte que lorsque des signaux de sélection sont appliqués à la seconde ligne de mots (WW) et à la seconde ligne de bits (BW), le dispositif NDR est commuté au mode de passage de courant, alors que dans le cas inverse, le dispositif NDR se trouve en mode de blocage de courant.

24. Dispositif de mémoire selon la revendication 1, chaque cellule de mémoire comportant :

une première zone semi-conductrice fortement dopée avec un type de conduction de type « p » ou de type « n » ;
une deuxième zone dopée avec le type de conduction opposé à la première zone, et en contact avec la première zone ;
une troisième zone légèrement dopée avec un type de conduction de type « p » ou de type « n » ou non-dopée, et en contact avec la deuxième zone;
une quatrième zone dopée avec le même type de conduction que la première zone, en contact avec la troisième zone ;
une cinquième zone fortement dopée avec le type de conduction opposé à la première zone, en contact avec la quatrième zone,
dans lequel la grille est en contact avec au moins une partie de la surface de la deuxième zone par le biais d'un isolant.

25. Dispositif de mémoire la revendication 24, dans lequel la concentration de dopage de la troisième zone est inférieure à $10^{18}$ cm$^{-3}$.

FIG. 1

*VG*

7

6

*I*

| P⁺ | N | I | P | N⁺ |
|----|---|---|---|-----|

1 2 3 4 5

*V*

FIG. 2

*VG*

M1

T1 T2

*I*

FIG. 3

FIG. 4

FIG. 5

## FIG.6

## FIG.7

WRITE "1"

BL=Vss

→ BW$_H$-V$_D$

FIG.8A

FIG.8C

WRITE "0"

BL=BW$_H$

FIG.8B

BW = BW$_H$
WW =WW$_L$
WL = WL$_H$

FIG.8D

BW = BW$_L$
WW = WW$_H$
WL = WL$_L$

READ "1"

BL=Vss

→ BW$_H$-V$_D$

FIG. 9A

READ "0"

BL=Vss

BW = BW$_H$
WW = WW$_H$
WL = WL$_L$

FIG. 9B

STANDBY

BL=Vss

BW = BW$_L$
WW = WW$_H$
WL = WL$_L$

FIG. 10

FIG. 11

PR

BW$_H$+VT (2.5)

Vss (0)

YS$_j$

Vss(0)

BW$_H$+VT (2.5)

WL$_i$

WL$_L$(0)

WL$_H$(2.5)

WW$_i$

WW$_H$(1.5)

WW$_L$(0.75)

BW$_j$

BW$_L$(0.75)

BW$_H$(1.5)

I/O

Vss(0)

"1"    BW$_H$(1.5)

"0"    BW$_H$-V$_D$(0.6)

·········· unselected row or column

WRITE OPERATION

FIG.12

PR

BW$_H$+VT(2.5)

Vss(0)

YS$_j$

Vss(0)

BW$_H$+VT(2.5)

WL$_i$

WL$_L$(0)

WL$_H$(2.5)

WW$_i$

WW$_H$(1.5)

BW$_j$

BW$_L$(0.75)

BW$_H$(1.5)

I/O

Vss(0)

"0"    BW$_H$-V$_D$(0.6)

"1"

·········· unselected row or column

READ OPERATION

FIG.13

EP 1 420 413 B1

**FIG. 14**

**FIG. 15**

FIG.16

FIG.17

EP 1 420 413 B1

FIG.18A

FIG.18B

FIG.18C

FIG.18D

FIG.18E

FIG.18F

54
53
52
51 N⁺
50 P
48 N⁺

58
57

N⁺
P
N⁺

N⁺
P
N⁺

SiO₂

39
39'

P
N

Si substrate

A    59    B         56         55                                              29              C

FIG.18G

54
53
52
51 N⁺
50 P
48 N⁺

60
62

N⁺
P
N⁺

N⁺
P
N⁺

61

SiO₂

39
39'

P
N

Si substrate

A    59    B         56         55                                              29              C

EP 1 420 413 B1

FIG.18H

FIG.18I

EP 1 420 413 B1

EP 1 420 413 B1

FIG.18J

FIG.18K

FIG.18L

FIG.18M

FIG.18N

FIG.18O

FIG. 19

FIG. 20

FIG. 21

FIG. 22A

FIG. 22B

FIG. 22C

FIG. 22D

72 74 72 74 72 74 72 74 72 74 72

SiO₂

Si substrate

## FIG. 22E

75 74 75 74 75 74 75 74 75 74 75

SiO₂

Si substrate

1            5      20      20

## FIG. 22F

76 74 76 74 76 74 76 74 76 74 76

SiO₂

Si substrate

## FIG. 22G

74      74            74      74

SiO₂

Si substrate

## FIG. 22H

FIG. 23

FIG. 24

FIG. 25
(PRIOR ART)

BL$_1$  BL$_2$

WW$_1$  WL$_1$  WW$_2$  WL$_2$

M11  M12  M21  M22

M1  M2  T1  T2  N

Vref

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 50009156 A
- JP 57208177 A
- US 5689458 A
- US 6128216 A
- US 6229161 A

### Non-patent literature cited in the description

- **T. YAMASHITA.** Semiconductor negative differential resistance devices. *Matusita Electric Industrial Co. Ltd.,* 09 October 1970
- **Y. OONO.** *Semiconductor negative differential resistance devices,* 17 June 1981
- **H. KURIYAMA.** Semiconductor memory device having negative resistance element operated stably with single low power source. *Mitubishi,* 18 November 1997
- **W. P. NOBLE JR. ; L. FORBES.** High Density Planar SRAM Cell with Merged Transistors. *Micron Technology,* 03 October 2000
- **F. NEMATI ; J. D. PLUMMER.** Semiconductor capacitively-coupled NDR device and its applications in high-density high-speed memories and in power switches. *Stanford University,* 08 May 2001